(19) Europäisches Patentamt

European Patent Office

Office européen des brevets

(11) EP 0 789 937 B1

(12) **EUROPÄISCHE PATENTSCHRIFT**

(45) Veröffentlichungstag und Bekanntmachung des Hinweises auf die Patenterteilung:
**17.05.2000   Patentblatt 2000/20**

(21) Anmeldenummer: **95936535.4**

(22) Anmeldetag: **23.10.1995**

(51) Int Cl.⁷: **H01L 41/04**, H01L 41/09, H02N 2/16

(86) Internationale Anmeldenummer:
**PCT/EP95/04148**

(87) Internationale Veröffentlichungsnummer:
**WO 96/13868 (09.05.1996 Gazette 1996/21)**

(54) **PIEZOELEKTRISCHER MOTOR**

PIEZOELECTRIC MOTOR

MOTEUR PIEZO-ELECTRIQUE

(84) Benannte Vertragsstaaten:
**FR GB**

(30) Priorität: **31.10.1994  DE 4438876**
**17.06.1995  DE 19522072**

(43) Veröffentlichungstag der Anmeldung:
**20.08.1997   Patentblatt 1997/34**

(73) Patentinhaber: **Pi Ceramic GmbH**
**07589 Lederhose (DE)**

(72) Erfinder: **WISCHNEWSKIY, Wladimir**
**D-07589 Münchenbernsdorf (DE)**

(74) Vertreter: **Bock, Gerhard, Dipl.-Ing. et al**
**Patentanwaltsbüro Pfeiffer & Partner**
**Winzerlaer Strasse 10**
**07745 Jena (DE)**

(56) Entgegenhaltungen:
**EP-A- 0 297 574       EP-A- 0 360 975**
**EP-A- 0 424 141       EP-A- 0 495 665**
**US-A- 4 723 085       US-A- 5 336 958**

**Beschreibung**

Die Erfindung betrifft einen piezoelektrischen Motor gemäß der Gattung der Patentansprüche. Sie ist besonders als elektrischer Miniaturmotor für stetige oder schrittweise Drehbewegungen verwendbar. Der erfindungsgemäße Motor kann in Automatisierungssystemen, in der Robotertechnik, in Werkzeugmaschinen zur genauen Bewegung der Schneidwerkzeuge, in Kraftfahrzeugen als Fensterheber- und Scheibenwischermotor und als Antrieb für die Sitzeinstellung verwendet werden. Er kann auch in trägheitsfreien Antrieben von Fersehantennen und anderen Vorrichtungen, in denen große Drehmomente bei relativ kleinen Drehgeschwindigkeiten erforderlich sind, angewendet werden.

Bekannt sind piezoelektrische Motoren, in denen die Umwandlung der elektrischen Energie in die Drehbewegung eines Rotors mit Hilfe piezoelektrischer Oszillatoren erfolgt, die in sich zwei Resonatoren für zwei unterschiedliche Typen von Stehwellen vereinigen, siehe u.a. US-A-4019073. Bei diesen Motoren bereitet es Schwierigkeiten, die Resonanzfrequenzen der zwei unterschiedlichen Stehwellentypen sowohl über einen großen Temperaturbereich als auch bei Einwirkung von mechanischen Kräften in Übereinstimmung zu bringen.

Dieser Nachteil ist piezoelektrischen Motoren nicht zueigen, die auf dem Prinzip der Erzeugung von akustischen Wanderwellen mit Hilfe zweier gleichartiger Stehwellen beruhen, siehe z.B. Axel Fröschler, Analyse eines Piezo-Wanderwellenmotors, Dissertation, Stuttgart, 1992, S. 48ff. Nachteilig ist bei diesen Motoren, daß in ihnen akustische Wellen verwendet werden und daß deshalb das die Wanderwelle erzeugende Piezoelement als dünner Ring ausgeführt ist, der auf dem metallischen Wellenleiter mit Hilfe eines elastischen organischen Klebers befestigt ist. Ebenfalls als Ringe oder Scheiben ausgebildet, mit einem zusätzlich angefügten elastischen Wellenleiter versehen bzw. zu versehen und deshalb nachteilig sind die Piezoelemente oder Vibratoren in den EP-A-0424141, EP-A-0495665, US-A-4723085, US-A-5336958. Die Verwendung elastischer Wellen und das im Verhältnis zum Gesamtvolumen des Wellenleiters kleine Volumen des Piezoelementes bedingen außerdem eine niedrige Effektivität der elektromechanischen Energieumwandlung. Damit erhöht sich wesentlich die Erregerspannung für den Motor. Die Verbindung des Piezoelementes mit dem metallischen Wellenleiter mittels organischer Kleber begrenzt die maximale vom Motor abgebbare mechanische Leistung, verringert seinen Wirkungsgrad und senkt die Funktionssicherheit. Das Piezoelement eines Motors für solche Wellen weist eine unterschiedlich ausgerichtete Polarisation auf, wodurch die Herstellung erschwert und der Motor verteuert wird. Das hat zur Folge, daß die piezoelektrischen Motoren mit Wanderwellen nicht mit den preiswerten elektromagnetischen Motoren konkurrieren können.

Darüber hinaus offenbart die EP-A-0424141 im wesentlichen einen Antriebssteuerkreis für einen Ultraschallschrittmotor, der an eine Vielzahl und eine bestimmte Anordnung und Ausbildung von piezoelektrischen Vibratoren gebunden ist. Die EP-A-0495665 beinhaltet einen Ultraschallschrittmotor, bei dem die oszillierenden Mittel sowohl mit dem Rotor als auch mit dem Stator verbunden sein können. Der Stator ist mit besonderen Kontaktteilen versehen, die durch eine bestimmte Oszillatorschaltung seriell nacheinander mit dem Rotor in Kontakt gebracht werden. Ein Schwingungswellenmotor gemäß der US-A-4723085 erzeugt unter Zuhilfenahme von Torsionsschwingungen eine Rotorbewegung.

Abgesehen davon, daß dabei im wesentlichen nur eine wechselnde punktuelle Berührung zwischen der Funktionsfläche des Oszillators und dem Rotor erfolgt, wirkt dort die größte Schubkomponente nicht in Antriebsrichtung, sondern in radialer Richtung. Sie geht damit dem Antrieb verloren. Ein Ultraschallmotor der US-A-5336958 hat zwei unterschiedliche Elektrodenanordnungen, von denen jede ein piezoelektrisches Glied kollektiv beeinflußt, das eine Vielzahl von Polarisationsrichtungen aufweist, die im Herstellungsprozeß den piezoelektrischen Gliedern gezielt aufgeprägt werden müssen.

Ziel der Erfindung ist die Entwicklung eines piezoelektrischen Motors, mit einen hocheffektiven Oszillator, der bei niedriger Erregerspannung eine maximale mechanische Leistung, eine hohe Funktionssicherheit und einen geringen Preis ermöglicht.

Es soll ein piezoelektrischer Motor geschaffen werden, bei dem eine sich in einem Kreis auf einer Friktionsfläche eines Oszillators bewegende Wanderwelle durch akustische Longitudinalwellen erzeugt wird und der Oszillator nicht aus einzelnen, gefügten mechanischen oder magnetischen Elementen besteht, sondern monolithisch gestaltet ist.

Die gestellte Aufgabe wird durch die kennzeichnenden Merkmale des ersten Patentanspruchs gelöst. Der gemäß der Erfindung erforderliche im wesentlichen hohlzylindrische Wellenleiter ist im folgenden vielfach auch als zylindrisch beschrieben. Auf Grund der Erzeugung von akustischen Longitudinalwellen gleicher Amplitude im monolithischen piezoelektrischen Oszillator wird die Wanderwelle zum Entstehen gebracht, die sich auf einem Kreis auf der Friktionsfläche des Oszillators bewegt und dabei ständig und elastisch Kontakt mit dem Rotor hält und auf Grund der sich auf einer geschlossenen Bahn bewegende, auf einer Linie liegende Punkte der Oszillatoroberfläche ein Drehmoment an den Rotor weitergeben. Da das maximal mögliche Volumen des Oszillators des erfindungsgemäßen Motors aus einem piezoelektrischen Material, vorzugsweise Keramik, gefertigt ist und für die Erzeugung von akustischen Wellen verwendet wird, verfügt der Motor über den maximal möglichen effektiven elektromechanischen Koeffizienten. Dies senkt wesentlich die Anregungsspannung. Außerdem erfolgt in der vorgeschlagenen Konstruktion kein Verkleben des Piezoelementes mit dem Wellenleiter mittels eines Klebers, der vorzugsweise aus organischen Komponenten besteht. Dies ermöglicht maximale mechanische Spannungen im Oszillator des Motors, die nur durch die Festigkeit der Keramik beschränkt werden und damit maximale mechanische Leistungen. Das Piezoelement des erfindungsgemäßen Motors ist in einer Richtung gleichgerichtet polarisiert, was seine Herstellung gegenüber vergleichbaren elektromagnetischen Motoren vereinfacht und kostengünstiger gestaltet.

Die vorliegende Erfindung kann in unterschiedlichen Varianten realisiert werden. Beispielsweise kann in einer einfachen Form der Erfindung zwei unabhängigen Generatoren für Stehwellen ein dritter, von den zwei ersten Generatoren abhängiger Generator zugeordnet sein, der derart durch die beiden ersten Generatoren determiniert ist, daß er mit ihnen zusammen einen Teiler für die von einer Anordnung zur Spannungserzeugung gelieferten Spannungen und einen Summenbildner für die durch die beiden ersten Generatoren geteilten Spannungen darstellt. Die drei Generatoren befinden sich auf einem im wesentlichen hohlzylindrischen piezoelektrischen Körper, der im Grenzfall eine geringe Höhe oder zueinander geneigte Mantel- oder Frontflächen aufweist. Diese Ausführungsform ermöglicht die Vereinfachung der Konstruktion durch Verzicht auf eine Erregerquelle für die Stehwellengeneratoren. Eine weitere günstige Ausführungsform der Erfindung ergibt sich, wenn der geschlossene Wellenleiter als zylindrischer, aus Piezokeramik gefertigter Körper ausgeführt ist, wobei die Stehwellengeneratoren als Abschnitte paralleler Elektroden ausgebildet sind. In dieser Ausführungsvariante stellt das gesamte Oszillatorvolumen das piezoelektrisch aktive Medium dar, und ein solcher Motor besitzt einen maximal möglichen elektromechanischen Koeffizienten. In diesem Fall ist die elektrische Erregerspannung für den Motor minimal. Da in der Konstruktion des Oszillators keine Klebeverbindung mit organischen Kleber vorgesehen ist, können im Oszillator maximal zulässige mechanische Spannungen erzeugt werden, die nur durch die Materialfestigkeit des Wellenleiters begrenzt sind. Das ergibt maximale Schwingungsbewegungen der Punkte der Funktionsfläche des Oszillators, was wiederum eine maximale mechanische Leistung an der Motorwelle bewirkt. Das Fehlen von Klebestellen mit organischem Kleber verringert die mechanischen Verluste im Oszillator des Motors und erhöht dadurch den Wirkungsgrad. Außerdem wird dadurch die Funktionssicherheit des Motors erhöht, da eine Zerstörung von Klebstellen bei einem hohen Anregungspegel ausgeschlossen ist.

Erfindungsgemäß kann die Funktionsfläche des Oszillators vorteilhaft mit einer dünnen verschleißfesten Friktionsschicht versehen sein, die in Kontakt mit dem Rotor tritt. In dieser Ausführungsvariante können mittels der Friktionsschicht die Friktionskennwerte für die Funktionsfläche des Oszillators vorgeben werden, was eine Erhöhung des Drehmomentes des Motors bewirkt.

In einer der Ausführungsvarianten der Erfindung kann die Friktionsschicht vollständig aus einem eine chemische Verbindung mit der piezoelektrischen Keramik bildenden Material, z.B. Glas, Metall oder ein anderer Werkstoff, gefertigt werden. Ein Motor, bei dem die Friktionsschicht eine chemische Verbindung mit dem Oszillator bildet, funktioniert an der Verbindungsstelle zerstörungsfrei bis zu der im Oszillator maximal zulässigen mechanischen Spannung. Bei einer weiteren vorteilhaften Ausführungsform besteht die Friktionsschicht aus einer Grund- und einer Zwischenschicht. Die Grundschicht bestimmt die Friktionseigenschaften und die Zwischenschicht bildet eine chemische Verbindung mit dem Piezomaterial. Eine solche Ausführungsvariante ermöglicht eine bedeutende Erweiterung der Anzahl der einsetzbaren Friktionswerkstoffe. In der folgenden Ausführungsvariante kann die Friktionsschicht aus einer Materialmischung bestehen, deren Grundlage ein Material bildet, das eine chemische Verbindung mit der Piezokeramik eingeht, und als Füllstoff ein Material verwendet, das den Reibungskoeffizienten der Friktionsschicht erhöht. In dieser Ausführungsvariante kann der notwendige Wellenwiderstand der Friktionsschicht durch Ändern des Verhältnisses der eingesetzten Werkstoffe ausgewählt werden. In einer anderen Ausführungsvariante kann die Friktionsschicht aus einem porösen Material mit hohen Reibungskoeffizienten und hoher mechanischer Festigkeit gefertigt werden, wobei die Poren dieses Werkstoffes mit einen Material aufgefüllt werden können, das eine chemische Verbindung mit der Piezokeramik bildet. Auf diese Weise lassen sich besonders feste, eine lange Funktionsdauer des Motors im Schrittbetrieb gewährleistende Friktionsschichten herstellen.

Zur elektrischen Verschaltung des erfindungsgemäßen piezoelektrischen Motors können vorteilhaft Leistungsverstärker verwendet werden, die über eine Phasenschieberkette mit der Erregerquelle des Grundgenerators verbunden sind, die Erregerquellen der Zusatzgeneratoren darstellen. In dieser Variante ist eine gute Abstimmung aller Generatoren sowohl in einem großen Temperatur- als auch einem mechanischen Belastungsbereich möglich, was die Betriebsstabilität des erfindungsgemäßen Motors verbessert. Außerdem ist vorteilhaft eine Ausführungsvariante möglich, in dem die Erregerquellen der Zusatzgeneratoren mit Vorrichtungen zur Umpolung des Phasenwinkels des Signals ausgestattet sind. Dies ermöglicht die Umkehrung der Drehrichtung des Rotors. Erfindungsgemäß kann auch die Erregerquelle des Grundgenerators durch einen frequenzgesteuerten Spannungsgenerator mit einem Steuereingang für die Frequenz gebildet werden. Eine solche Variante ermöglicht eine gleichmäßige Regelung der Rotordrehfrequenz durch Ändern der Frequenz der Erregerquelle des Grundgenerators.

In einer weiteren Varianten kann der piezoelektrische Motor so ausgeführt sein, daß der Grundgenerator für Stehwellen und seine Erregerquelle eine positive Rückkopplung aufweisen und sie zusammen einen elektromechanischen Autogenerator bilden. Dabei befindet sich die Frequenz der Stehwellengeneratoren immer im Bereich der Oszillatorresonanzfrequenz, wodurch die Stabilität der Drehfrequenz des Rotors erhöht wird.

In einer Ausführungsvariante des erfindungsgemäßen Motors kann der positive Rückkopplungszweig mit einem Impedanzelement verbunden sein, das wiederum in Reihe mit dem Grundgenerator für Stehwellen geschaltet ist. Auch ist es möglich, den positiven Rückkopplungszweig mit einem Stromwandler zu verbinden, der in Reihe mit dem Grundgenerator für Stehwellen geschaltet ist.

Schließlich kann der positive Rückkopplungszweig mit der Rückkopplungselektrode verbunden sein, die, bedingt durch die vom Hauptgenerator erzeugten Stehwellen, am Ort des Auftretens der maximalen mechanischen Spannungen angeordnet ist.

Die letztgenannten drei Varianten gewährleisten eine sichere Erregung des elektromechanischen Generators bei der Oszillatorresonanzfrequenz. Eine weitere vorteilhafte Gestaltung des Motors ist mit einem elektronischen Schalter zur Unterbrechung des positiven Rückkopplungszweiges ausgestattet. In diesem Fall ist ein Schrittregime leicht realisierbar, was die Anwendung als Schrittmotor ermöglicht.

Weitere Merkmale der Erfindung ergeben sich aus der folgenden Figurenbeschreibung. Anhand der schematischen Zeichnung wird die Erfindung an Ausführungsbeispielen und nicht-erfindungsgemäßen Beispielen näher erläutert. Es zeigen:

Fig. 1      die erfindungswesentlichen Teile eines erfindungsgemäßen Motors in perspektivischer Darstellung,
Fig. 2      einen Oszillator in abgewickelter Darstellung,
Fig. 3      Diagramme der Erregerspannungen,
Fig. 4      eine stehwellenartige Verformung eines Oszillators bei angelegter Erregerspannung,
Fig. 5      ein Diagramm einer Erregerspannung,
Fig. 6      einen Augenblickszustand der Funktionsfläche des Oszillators bei Erzeugung einer Stehwelle,
Fig. 7      Diagramme zur Darstellung des Überlagerungsprozesses bei Verformung der Funktionsfläche,
Fig. 8      ein vollständiges Bild des Bewegungsablaufs von Punkten der Funktionsfläche des Oszillators bei Erzeugung einer Stehwelle,
Fig. 9      eine weitere Darstellung des Bewegungsablaufs von Punkten der Funktionsfläche des Oszillators bei Erzeugung einer Stehwelle,
Fig. 10     eine Darstellung zur Herausbildung der Bewegungsbahn eines Punktes mit der Funktionsfläche des Oszillators,
Fig. 11     eine Darstellung der Phasenbewegung von Punkten der Funktionsfläche des Oszillators,
Fig. 12     mögliche Bewegungslinien von Punkten der Funktionsfläche,
Fig. 13     ein Elementarvolumen eines Oszillators und sein Ersatzschaltbild,
Fig. 14     ein vollständiges Ersatzschaltbild des erfindungsgemäßen Oszillators,
Fig. 15     ein vereinfachtes Ersatzschaltbild dieses Oszillators,
Fig. 16     elektromechanische Kennwerte des erfindungsgemäßen Motors,
Fig. 17     verschiedene Oszillatorformen,
Fig. 18     Varianten verschleißfester Schichten,
Fig. 19     Varianten für die Elektroden,
Fig. 20     eine besondere Elektrodenanordnung,
Fig. 21     eine unsymmetrische Wanderwelle,
Fig. 22     Blockschaltbilder zur Erläuterung des Grundprinzips der Oszillatoransteuerung,
Fig. 23     einen Oszillator mit zwei unabhängigen Generatoren und einem von diesen abhängigen Generator,
Fig. 24     ein Fig. 23 entsprechendes elektrisches Ersatzschaltbild,
Fig. 25     ein Blockschaltbild zur Selbsterregung des Oszillators,
Fig. 26     ein Blockschaltbild mit frequenzgesteuerten Autogenerator,
Fig. 27     ein Blockschaltbild einer einen elektromechanischen Autogenerator darstellenden Anordnung,
Fig. 28     ein Blockschaltbild eines Stromwandlers,
Fig. 29     eine Rückkopplungselektrode und ihre Wirkungsweise,
Fig. 30     ein Blockschaltbild mit Rückkopplungselektrode,
Fig. 31     ein Blockschaltbild des Schrittmotors,
Fig. 32     eine Motorkonstruktion mit langgezogenem Oszillator im Längsschnitt,
Fig. 33     eine Draufsicht auf den Oszillator gemäß Fig. 32,
Fig. 34     eine Motorkonstruktion mit Ringoszillator,
Fig. 35     eine Motorkonstruktion mit gestauchtem Gehäuse in Schnittdarstellung,
Fig. 36     eine in Fig. 35 dargestellte Motorkonstruktion teilweise in Ansicht und im Schnitt,
Fig. 37     eine Motorkonstruktion mit Paketwandlern in einem Axialschnitt A-A der Figur 38,
Fig. 38     eine Draufsicht von Fig. 37,
Fig. 39     eine Motorkonstruktion mit Magnetring in einem Axialschnitt,
Fig. 40     eine Prinzipschaltung mit frequenzgesteuertem Autogenerator,
Fig. 41     eine erste Motorschaltung als elektromechanischer Autogenerator,
Fig. 42     eine zweite Motorschaltung als elektromechanischer Autogenerator,

Fig. 43      eine Prinzipschaltung eines erfindungsgemäßen Motors als Schrittmotor und

Fig. 44      eine Prinzipschaltung für einen Motor mit zwei unabhängigen Generatoren und einem von diesen abhängigen Generator.

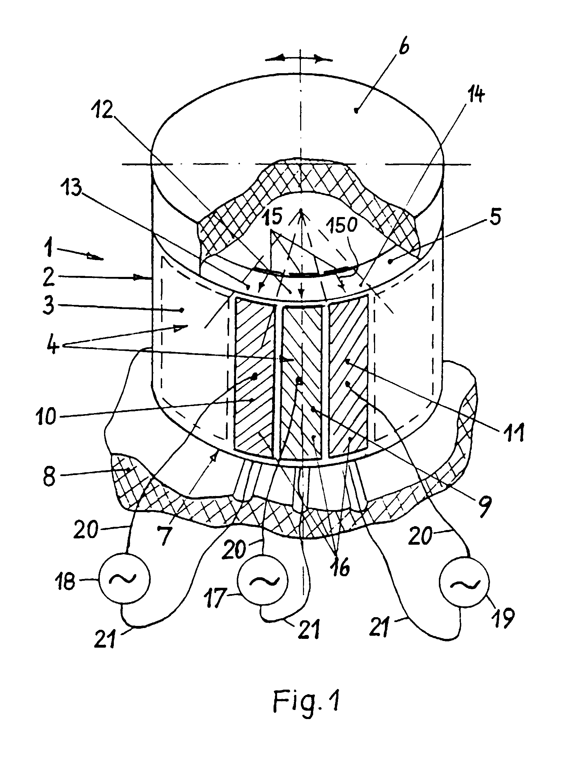

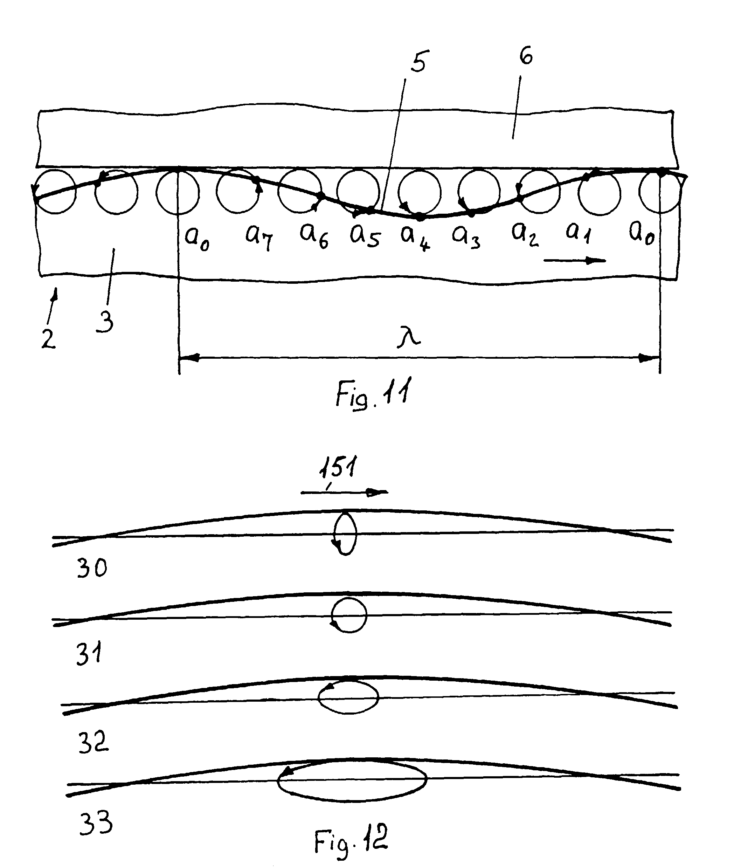

Der erfindungsgemäße piezoelektrische Motor enthält gemäß Fig. 11 einen Stator 1 mit einem zylindrischen Oszillator 2 in Form eines geschlossenen und aus piezoelektrischer Keramik gefertigten Wellenleiters 3. Der Wellenleiter 3 besitzt mindestens einen Generator 4 für eine elastische Wanderwelle im Körper des Wellenleiters 3. Ein Rotor 6 wird in der dargestellten Ausführungsform durch sein Eigengewicht an eine Stirnfläche (Funktionsfläche) 5 des Oszillators 2 angepreßt. Eine zweite nicht als Funktionsfläche dienende Stirnfläche 7 des Oszillators 2 stützt sich auf einer elastischen schallisolierenden Unterlage 8 ab, die im nicht dargestellten Gerätegehäuse angeordnet ist. Der Wanderwellengenerator 4 umfaßt einen Grundgenerator 9 und zwei Zusatzgeneratoren 10, 11 für Stehwellen. Jeder der Generatoren 9, 10, 11 belegt einen gleichgroßen Abschnitt 12, 13, 14 des zylinderförmigen Wellenleiters 3 und wird aus zwei parallen Elektroden 15, 16 mit zwischen ihnen befindlicher piezoelektrischer Keramik gebildet. Jede der Elektroden 15, 16 stellt eine in Längsrichtung auf den zylinderförmigen Wellenleiter 3 aufgetragene stromleitende metallische Schicht dar. Zur Aktivierung der Generatoren 9, 10, 11 ist die piezoelektrische Keramik zwischen den Elektroden 15, 16 in Normalenrichtung zu diesen Elektroden polarisiert. In Fig. 1 und in den folgenden ist die Polarisation mit Pfeilen 150 dargestellt.

Jeder der Stehwellengeneratoren 9, 10, 11 hat eine Erregerquelle (Spannungsquelle) 17, 18, 19. Die Anschlüsse 20, 21 jeder Erregerquelle 17, 18, 19 sind mit den Elektroden 15 und 16 der entsprechenden Generatoren 9, 10, 11 verbunden. An den Anschlüssen 20, 21 und damit an den Elektroden 15, 16 der Stehwellengeneratoren 9, 10, 11 liegen die entsprechenden Spannungen

$$U_1 = U \cdot \sin\omega t, \ U_2 = U \cdot \sin(\omega t \pm 120°), \ U_3 = U \cdot \sin(\omega t \mp 120°) \ \text{an}.$$

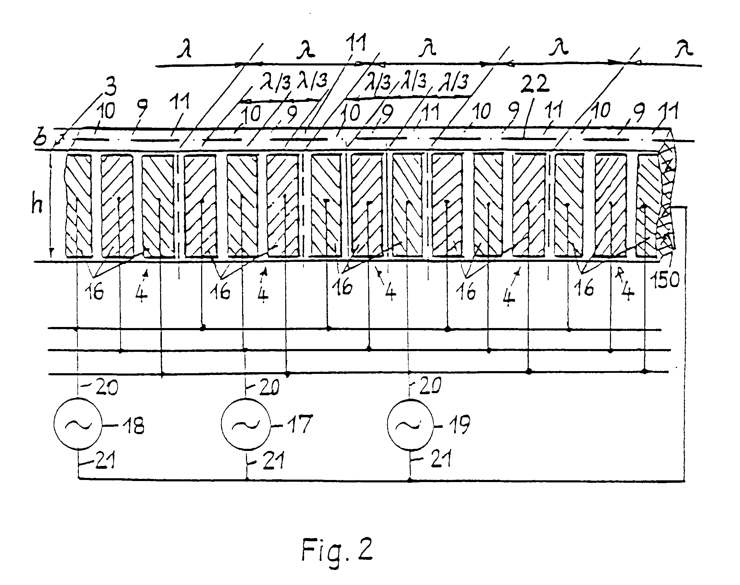

In Fig. 2 ist ein abgewickelter zylinderförmiger Wellenleiter 3 mit der Höhe h und der Breite b dargestellt. Die Länge des Wellenleiters 3 entlang der Mittellinie 22 muß ein ganzzahliges Vielfaches der Wellenlänge $\lambda$ betragen, die im Wellenleiter durch die Stehwellengeneratoren für 9, 10, 11 erzeugt wird. Die Länge jedes Stehwellengenerators 9, 10, 11 längs der Mittellinie 22 beträgt $\lambda/3$. Die Zusatzgeneratoren 10, 11 sind, bezogen auf den Grundgenerator 9, längs der Mittellinie 22 um den entsprechenden Betrag von $\pm \lambda/3$ verschoben. Jede Gruppe von drei Stehwellengeneratoren 9, 10, 11 bildet einen Wanderwellengenerator 4. Der dabei von einem Wanderwellengenerator 4 eingenommene Platz längs der Mittellinie des zylindrischen Wellenleiters 3 ist gleich der Wellenlänge $\lambda$. Die Zahl der Generatoren 4 ist frei wählbar und hängt von der Länge der Mittellinie 22 des zylindrischen Wellenleiters 3 ab. Der in Fig. 2 dargestellte Wellenleiter 3 hat fünf Wanderwellengeneratoren. Alle fünf Generatoren 4 sind elektrisch parallel geschaltet. Eine solche Schaltung bedeutet, daß der Anschluß 20 jeder der Erregerquellen 17, 18, 19 mit der entsprechende Elektrode 15 der Generatoren 9, 10, 11 entsprechend verbunden ist. In Figur 2 sind die Anschlüsse 21 der Erregerquellen 17, 18, 19 miteinander verbunden und an die Elektrode 16, die die gemeinsame Elektrode für die Generatoren 9, 10, 11 bildet, angeschlossen. Durch die Erregerquellen 17, 18, 19 werden sinusförmige Spannungen gleicher Amplitude und Frequenz, die zueinander phasenverschoben sind, bereitgestellt. Die Phasenverschiebung der elektrischen Spannungen der Erregerquellen 18, 19 bezogen auf die Spannung der Erregerquelle 17 beträgt $\pm 2\pi/3$ ($\pm 120°$).

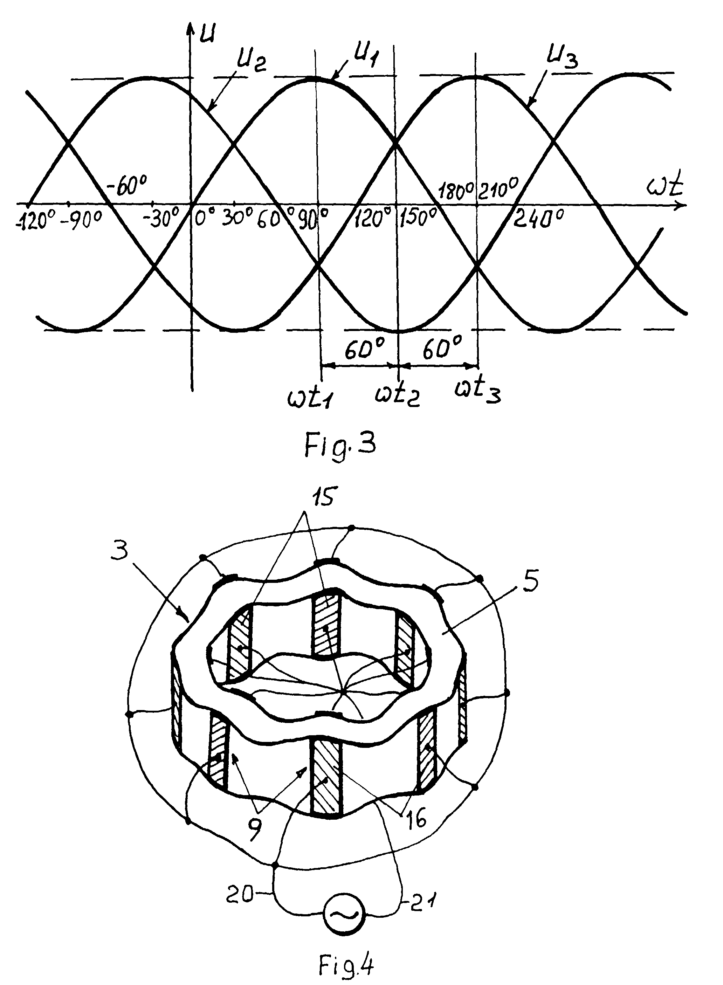

Figur 3 zeigt die Diagramme der Spannungsverläufe. Die Spannung $U_1$ wird durch die Erregerquelle 17, die Spannung $U_2$ durch die Erregerquelle 18, die Spannung $U_3$ durch die Erregerquelle 19 bereitgestellt.

In Fig. 4 ist eine Longitudinalstehwelle im Wellenleiter 3 und damit seiner Funktionsfläche 5 dargestellt, die durch einen der Generatoren 9, 10, 11 erzeugt wird, wobei dieser Generator mit einer sinusförmigen Spannung $U_i = U \cdot \sin\omega t$ der entsprechenden Erregerquelle 17, 18, 19 angeregt wurde. Der in Fig. 4 dargestellte Wellenleiter 3 besitzt acht parallel geschaltete, gleiche Stehwellengeneratoren 9, 10 oder 11. Jeder dieser Generatoren erzeugt eine Stehwelle mit sechszehn Maxima bzw. Minima. Die Anzahl gleicher Generatoren 9, 10, 11 wird bei der Erfindung durch die Zahl der Wanderwellengeneratoren 4 bestimmt.

Während des Betriebs des erfindungsgemäßen Motors werden durch die Stehwellengeneratoren 9, 10, 11 unabhängig drei Stehwellen gleicher Amplitude und Wellenlänge erzeugt, die im Raum längs der Mittellinie 22 (Fig. 2) des Wellenleiters 3 zueinander um $\lambda/3$ verschoben sind. Die Phasen dieser Wellen unterscheiden sich voneinander um den Betrag von $\pm 2\pi/3$ ($\pm 120°$).

Im folgenden werden die grundsätzlichen Funktionen des erfindungsgemäßen piezoelektrischen Motors anhand der Figuren 1 bis 16 näher beschrieben.

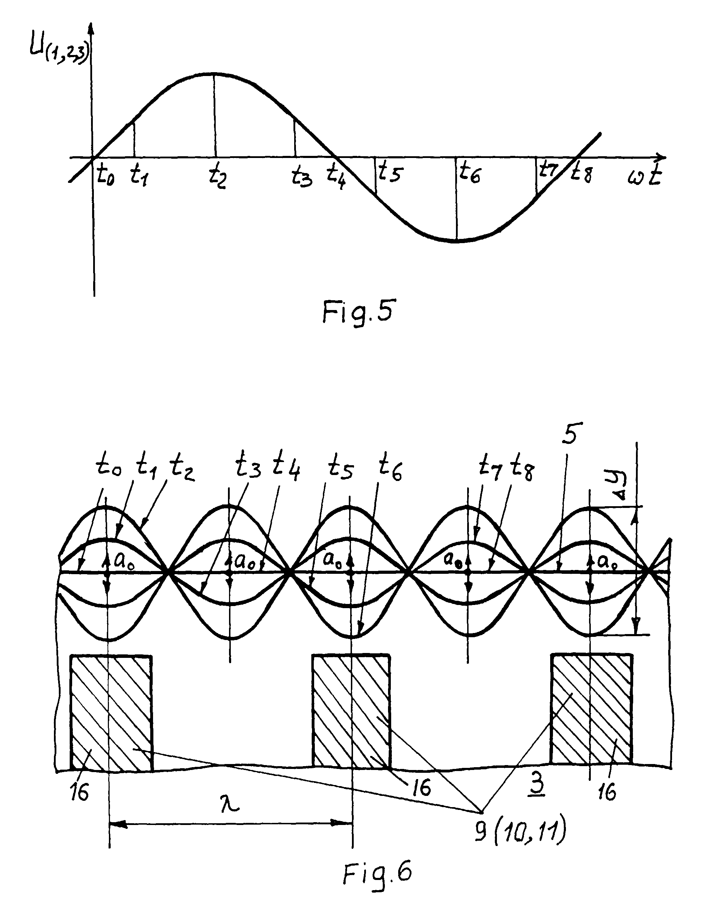

An jeden Stehwellengenerator 9, 10, 11 (Fig. 11 und 2) wird die von der entsprechenden Erregerquelle 17, 18, 19 bereitgestellte Erregerspannung $U_1$, $U_2$, $U_3$ (Fig. 3) angelegt. Jede Spannung steuert den entsprechenden Generator 9, 10, 11. Diese Generatoren erzeugen im Wellenleiter 3 des Oszillators 2 drei identische Longitudinalstehwellen gleicher Amplitude, die im Raum, bezogen auf die Mittellinie 22 des Wellenleiters, zueinander um den Betrag $\pm \lambda/3$ und

bezogen auf die Zeit (Phase) um den Winkel ± $2\pi/3$ (± 120°) verschoben sind. In Fig. 4 ist eine dieser Wellen dargestellt. Da die Schwingungsamplitude des Oszillators 2 (2 bis 10 µm) im Verhältnis zu seinen Abmessungen (20 bis 100 mm) klein ist, wird jede Welle unabhängig von anderen erzeugt. Sie existieren unabhängig voneinander und verformen unabhängig voneinander die Funktionsfläche 5 des Oszillators 2. Die Verschiebung der Punkte des Oszillators 2 im wesentlichen rechtwinklig zur Funktionsfläche 5 ändert sich durch das Einwirken jeder einzelnen Welle nach einem Sinusgesetz, so daß auch die Verschiebung der Punkte der Funktionsfläche 5 nach diesem Gesetz und entsprechend der Änderung der sinusförmigen Erregerspannung erfolgt. Figur 5 zeigt das Diagramm der Spannungsverläufe eines der Stehwellengeneratoren 9, 10, 11 für den angegebenen Zeitabschnitt $t_0$-$t_8$ einer Schwingungsperiode.

Figur 6 zeigt die Phasen der Bewegung der Funktionsfläche 5 des Oszillators 2 für die Zeitabschnitte $t_0$-$t_8$. In den Diagrammen sind die sich in den Extremwerten der Transversalgeschwindigkeiten der Stehwellen befindlichen Punkte $a_0$ der Funktionsfläche 5 gekennzeichnet. Diese Punkte führen Schwingungen auf senkrecht zur Funktionsfläche 5 verlaufenden geraden Linien (strichliniert gezeichnet) aus. Werden gleichzeitig drei Stehwellen im Oszillator 2 erzeugt, überlagern sie sich. Die durch die Stehwellen hervorgerufenen Verformungen des Oszillatorkörpers 2 summieren sich ebenso wie die Verformungen der Funktionsfläche 5.

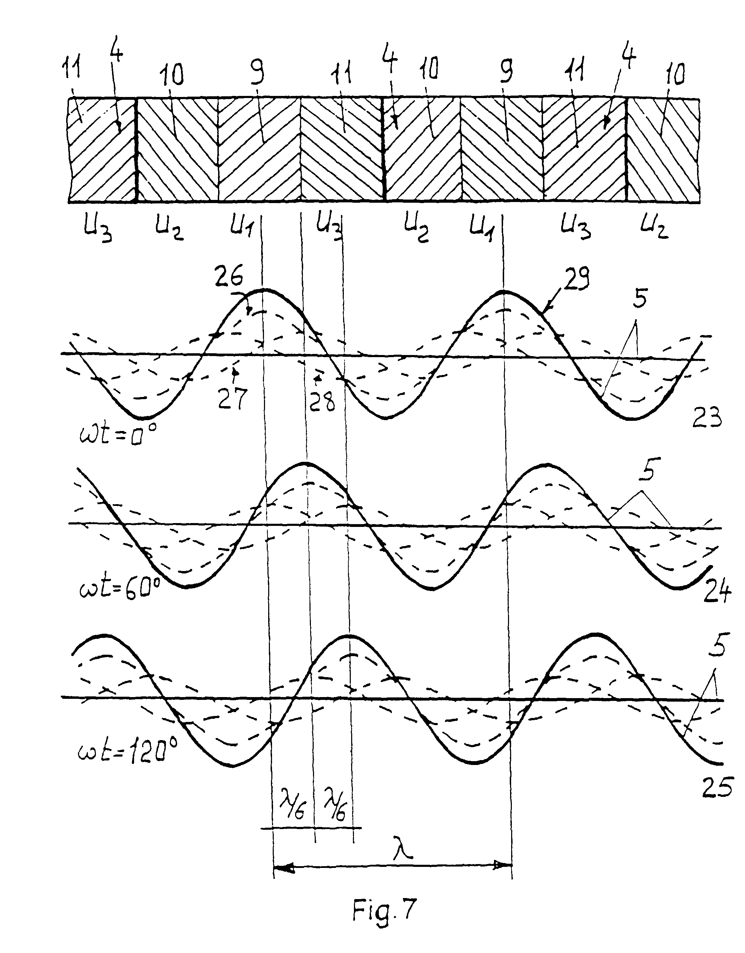

In Fig. 7 ist der Überlagerungsvorgang zur Verformung der Funktionsfläche 5 dargestellt. Die Angaben der Positionen 23, 24, 25 entsprechen den Zeitpunkten $t_1$, $t_2$, $t_3$ der Augenblickswerte der Erregerspannungen $U_1$, $U_2$, $U_3$ an den Generatoren 9, 10, 11 (Fig. 3). In Fig. 7 ist durch die gerissene Linien 26, 27, 28 der durch jede Stehwelle hervorgerufe Verformungszustand der Funktionsfläche 5 dargestellt. Mit der durchgehenden Linie 29 ist die überlagerte Verformung der Funktionsfläche 5 gekennzeichnet. Aus den Diagrammen 23, 24, 25 (Fig. 7) ist erkennbar, daß die überlagerte Verformung der Funktionsfläche 5 des Oszillators 2 eine sich weiterbewegende Welle 29 (Wanderwelle) des Oszillators 2 darstellt. Diese Welle 29 legt in einer Schwingungsperiode einen Weg zurück, der gleich der Wellenlänge $\lambda$ der Stehwelle ist. Die Amplitude der Wanderwelle ist gleich dem 1,5-fachen Amplitudenwert einer der Stehwellen.

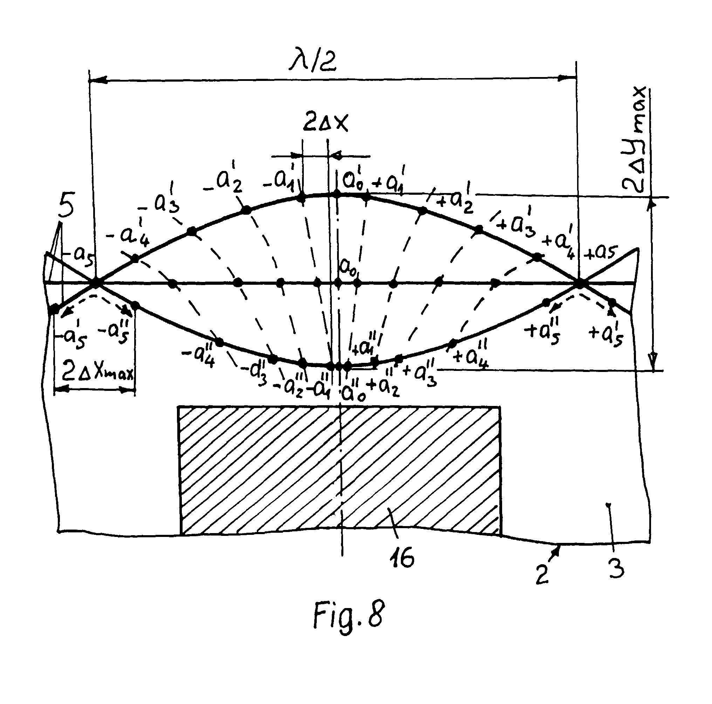

Gemäß Fig. 8 sind im erfindungsgemäßen Motor zwei grundsätzlich unterschiedliche Bewegungsabläufe für die Punkte auf der Funktionsfläche 5 des Oszillators 2 möglich. Im ersten Fall entfernen sich beim Aufblähen der stehenden Welle die Punkte $a_0$ bis $\pm a_5$ im Gipfelbereich voneinander. Die Funktionsoberfläche 5 dehnt sich dabei gewissermaßen aus. Im zweiten Fall nähern sich die Punkte $a_0$ bis $\pm a_5$ zueinander. Die Funktionsoberfläche wird zusammengepreßt. Der erste Fall kann sich bei geringer mechanischer Güte des Oszillators 2 und bei hohen elektromechanischen Koppelkoeffizienten der Piezokeramik einstellen. Auf die Punkte des Oszillators 2 wirken hauptsächlich die elektrischen Feldkräfte zwischen den Oszillatorelektroden 15, 16. In Abhängigkeit von Größe und Vorzeichen des Erregerfeldes entfernen sich alle Punkte des Oszillators 2 voneinander oder nähern sich an. Dabei können die Bewegungsbahnen der Punkte geneigte gekrümmte Linien oder geschlossene Ellipsen sein.

Figur 8 zeigt den vollständigen Bewegungsablauf der Punkte $a_1$-$a_5$ der Funktionsfläche 5 im Bereich der Wellenlänge des Wellenleiters 3 (Oszillator 2), der bei Erzeugung einer Stehwelle im Oszillator 2 gleich $\lambda/2$ ist. Der Bewegungslinie der Punkte $a_1$-$a_5$ (Fig. 8) ist durch gekrümmte gerissene Linien dargestellt. Der Wellenleiter 3 (Oszillator 2) dehnt sich abwechselnd aus (Punkte $\pm a_1'$, bis $\pm a_5'$) und preßt sich in seinen Schwingungsbäuchen (Punkte $\pm a_1''$ bis $\pm a_5''$) zusammen. Aus dem in Fig. 8 dargestellten Bewegungsablauf der Punkte $a_0$ bis $a_5$ ist ersichtlich, daß sich die in den Maxima der senkrechten Schwingungskomponenten befindlichen Punkte $a_0$ auf geraden, senkrecht zur Oberfläche 5 verlaufenden Linien bewegen. Der zylinderförmige Wellenleiter 3 des Oszillators 2 stellt einen elastischen Körper mit endlichen Abmessungen dar, dessen Elementarteilchen mittels Elastizitätskräften zusammengehalten werden. Dies hat zur Folge, daß bei der Erregung einer Longitudinalstehwelle, die Punkte des Wellenleiters 3 (Oszillator 2) sich, wie in Fig. 8 dargestellt, auf geneigten Bahnen bewegen, wobei sie sich abwechselnd einander annähern bzw. voneinander entfernen. Nur die sich in den Extremwerten befindlichen Punkte bewegen sich (schwingen) auf geraden senkrecht zur Oberfläche des zylinderförmigen Wellenleiters 3 verlaufenden Bahnen (siehe Fig. 6 und 8). Diese Punkte besitzen eine maximale Queramplitude $\Delta y_{max}$. Die restlichen Punkte bewegen sich auf geneigt zur Oberfläche des Wellenleiters verlaufenden Bahnen, wie in Fig. 8 dargestellt. Mit zunehmender Entfernung vom zentralen Punkt $a_0$ verringert sich ihre Queramplitude (in y-Richtung). Dies erklärt, warum jeder sich in einer gewissen Entfernung vom Punkt $a_0$ (Linie) des Maximums befindliche Punkt an der Funktionsfläche 5, eine Quer- und eine Längskomponente der Geschwindigkeit aufweist. Dabei erhöht sich mit Zunahme der Entfernung (Punkte $+a_n$ und $-a_n$) beiderseits des zentralen Punktes $a_0$ die Längskomponente (x-Richtung) der Geschwindigkeit und bei einer Entfernung von $\pm\lambda/4$ erreicht die Queramplitude ihren Maximalwert von $\Delta x_{max}$. Die Querkomponente $\Delta y$ ist in diesem Punkt minimal. Der nichtlineare Bewegungsverlauf (Krümmung) ist durch Inhomogenitäten des Wellenleitermaterials bei großen Schwingungsamplituden bedingt, was praktisch immer auftritt.

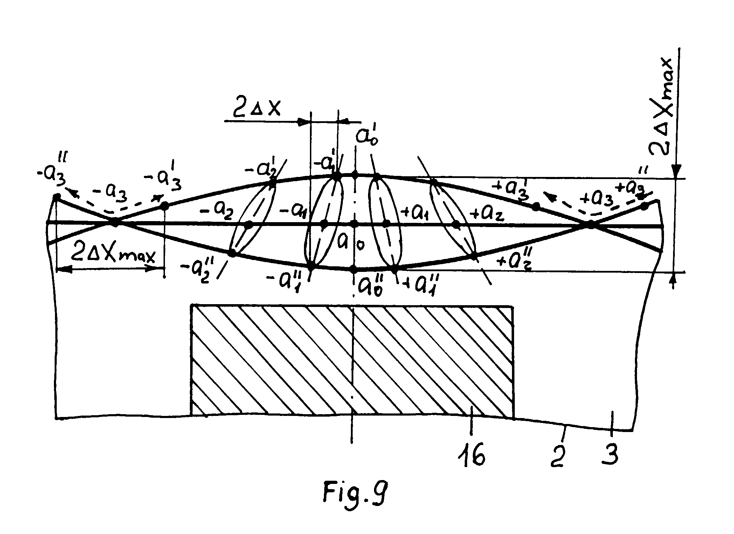

Fig. 9 erklärt den zweiten Bewegungsfall der Punkte $a_0$ bis $\pm a_3$ auf der Funktionsoberfläche 5 des Oszillators 2. Dieser Fall ist bei hoher mechanischer Güte des Oszillators 2 und kleinem elektromechanischen Koppelkoeffizienten des piezokeramischen Materials des Oszillators 2 möglich. In diesem Fall bilden die mechanischen, den Oszillatorkörper zusammenpressenden und dehnenden Kräfte aufgrund der Bewegung der akustischen Welle den Hauptgrund für die Bewegung der Punkte. In der Praxis stellen die Bewegungsbahnen der Punkte ellipsenähnliche, zur Oszillatoroberfläche unter einem Winkel geneigte Figuren dar.

Jeder der beiden betrachteten Fälle zur Bewegung der Punkte auf der Funktionsfläche des Oszillators 5 ändert das Funktionsprinzip des erfindungsgemäßen Motors nicht; jedoch gibt es einen wesentlichen Unterschied in der Bewegungsrichtung des Rotors 6.

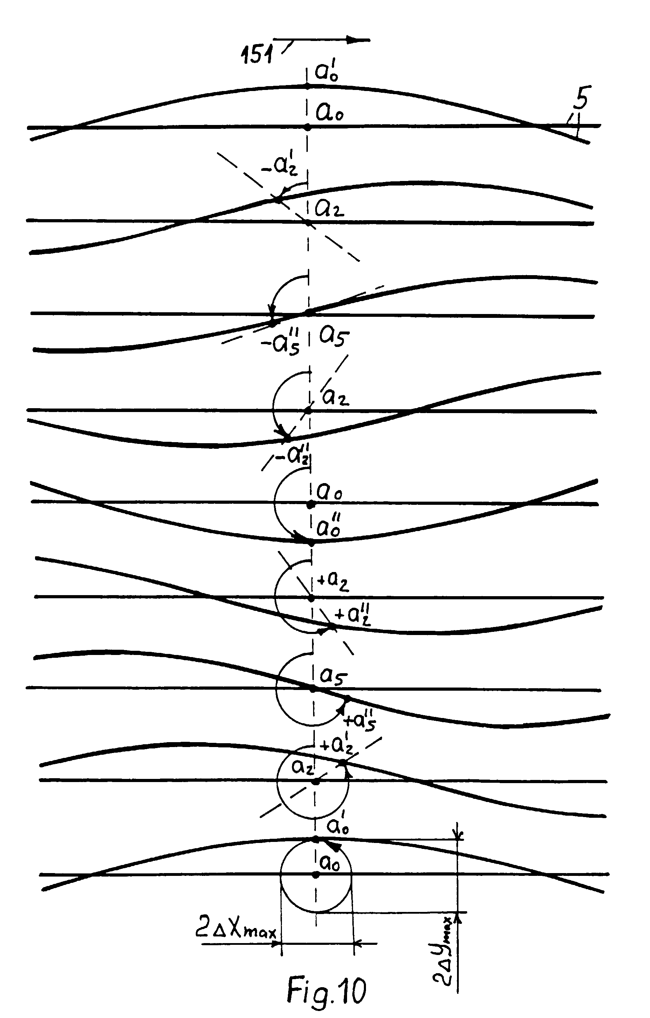

Gemäß Fig. 10 durchläuft bei Erzeugung einer Wanderwelle im Wellenleiter 3 des Oszillators 2 jeder Punkt der Funktionsfläche 5 des Oszillators 2 nacheinander die Positionen aller Punkte von $+a_n'$ bis $-a_n'$ und von $-a_n''$ bis $+a_n''$ und bewegt sich dabei auf einer geschlossenen Bahn, die im allgemeinen eine Ellipse und im Spezialfall einen Kreis darstellt. Die Bewegungsrichtung der Welle ist durch einen Pfeil 151 angegeben. Die maximale Höhe der Ellipse ist gleich der doppelten maximalen Queramplitude $\Delta y_{max}$. Die maximale Breite der Ellipse ist gleich der doppelten maximalen Längsamplitude $\Delta x_{max}$. Der Phasenwinkel zwischen Längs- und Querkomponente beträgt immer 90°. Wenn die Querkomponente $\Delta y$ gleich Null ist, erreicht die Längskomponente $\Delta x$ ihr Maximum und wenn die Längskomponente $\Delta x$ Maximum hat, ist die Querkomponente $\Delta y$ praktisch gleich Null.

Jeder Punkt an der Funktionsfläche 5 besitzt einen sich vom Punkt $a_{n\pm 1}$ unterscheidenden anderen Bewegungsablauf auf seiner elliptischen Bahn.

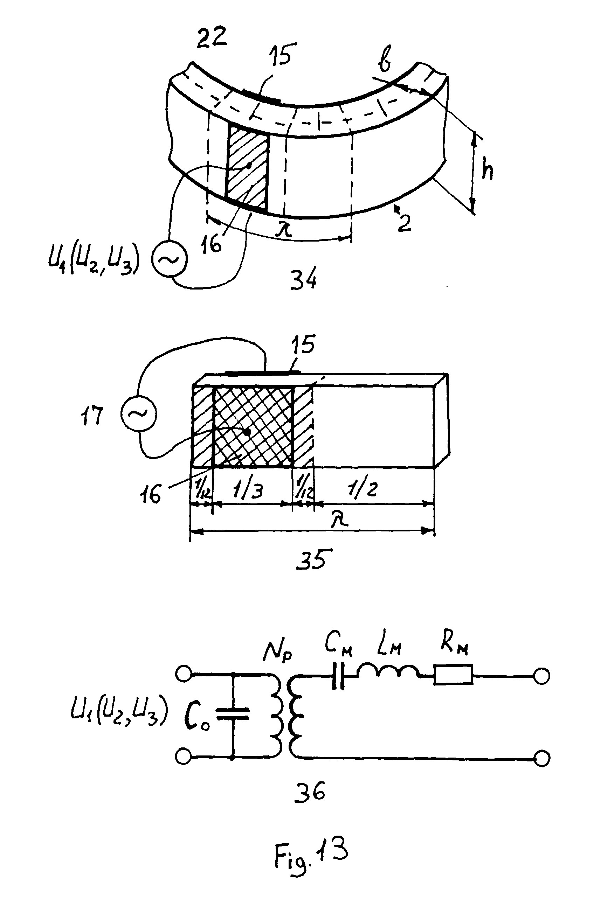

Fig. 11 gibt den Bewegungsablauf der Punkte $a_0$ bis $a_7$ der Funktionsfläche 5 wieder. Es ist erkennbar, daß die sich zum angegebenen Zeitpunkt im Wellenberg befindlichen Punkte $a_o$ Kontakt mit dem Rotor 6 haben. Auf Grund der Reibungskräfte übertragen diese Punkte der Funktionsfläche 5 ein Drehmoment auf den Rotor 6. Das Material des Rotors weist eine gewisse feststehende Verformbarkeit auf, so daß dieser Kontakt in der Praxis flächenhaft erfolgt, wobei die Kontaktfläche von den elastischen Materialeigenschaften des Rotors und von der Federkraft abhängt, die den Rotor 6 an die Funktionsfläche 5 des Oszillators 2 preßt. Praktisch hat also eine gewisse Anzahl sich auf dem Wellenberg der Wanderwelle befindlicher Punkte Kontakt mit dem Rotor und überträgt ihm ein Drehmoment. Die sich in den Wellentälern befindenden Punkte bewegen sich dabei in umgekehrter Richtung. Jeder Punkt der Funktionsfläche 5 durchläuft im Verlauf einer Schwingungsperiode einmal seine Bewegungsbahn. Die Zahl der den Rotor 6 kontaktierenden Teilflächen der Funktionsfläche 5 ist gleich der Zahl der Wellenlängen $\lambda$, die der Länge der Mittellinie 22 (Fig. 13) des Oszillators 2 entsprechen.

Die Drehrichtung der Ellipsen oder die Bewegungsrichtung der Punkte, die Kontakt zum Rotor 6 haben, hängt davon ab, ob die Punkte in den Wellenbergen der Stehwelle im Moment des Ausdehnens des Oszillatorwerkstoffes (Figuren 8 und 9) sich voneinander entfernen oder sich aufeinander zu bewegen. Wenn sich die Punkte voneinander entfernen, drehen sich die Ellipsen und der Rotor 6 entgegengesetzt zur Ausbreitungsrichtung der Wanderwelle.

Wenn die Punkte sich aufeinanderzubewegen, fallen die Drehrichtung von Ellipsen und Rotor 6 mit der Ausbreitungsrichtung der Wanderwelle zusammen. Dieser Fall wird hier nicht betrachtet. Das Verhältnis von Längs- zur Querkomponente $\Delta x/\Delta y$, d.h. der Bewegungsablauf des erfindungsgemäßen Motor wird hauptsächlich durch das Verhältnis der Wellenlänge $\lambda$ zur Höhe des Wellenleiters h bestimmt. Je größer dieses Verhältnis, um so mehr sind die Ellipsen längs der Funktionsfläche 5 gedehnt. Je kleiner dieses Verhältnis, desto mehr nähert sich die Bewegungsbahn der Punkte an die einer Kreisbahn an.

Die Oszillatorbreite (Wellenleiter) und die Elastizitätseigenschaften des Oszillatormaterials haben nur einen geringen Einfluß auf das Verhältnis der Komponenten $\Delta x/\Delta y$. Bei Motoren, bei denen die Bewegungsbahn der Punkte der Funktionsflächen 5 sich einer Kreisform annähert, beträgt das Verhältnis von Wellenlänge $\lambda$ zur Oszillatorhöhe h rund 2.

Figur 12 stellt mögliche Bewegungsbahnen von Punkten der Funktionsfläche 5 dar, und zwar zeigen Position 30 eine senkrecht zur Arbeitsoberfläche 5 langezogene Ellipse, Position 31 eine Bewegungsbahn in Kreisform, Position 32 eine in Richtung der Funktionsfläche 5 langgezogene Ellipse mit einem Achsenverhältnis von 1,5 und Position 33 eine Ellipse mit einem Achsenverhältnis von 4. Optimal für die Funktion des erfindungsgemäßen Motors ist eine Bewegungsbahn in Form einer in Richtung der Funktionsfläche 5 angezogenen Ellipse und mit einem Verhältnis der Komponenten im Bereich von 2 bis 5 (Positionen 32 und 33 in Fig. 12). In diesem Fall ist der tangential zur Funktionsfläche 5 ausgerichtete Energiefluß um 4 bis 25 mal größer als der senkrecht zu dieser Oberfläche ausgerichtete Energiefluß.

Das heißt, daß der größere Teil der Statorenergie potentiell in Rotorenergie umgewandelt wird.

Die Bewegungsbahn als Kreis (Position 31 in Fig. 12) stellt einen Grenzfall dar. Im Fall der senkrecht zur Funktionsfläche 5 (Position 30,

Fig.. 12) langgezogenen Ellipse dringt ein Großteil der Energie des Stators 2 in den Rotor 6 des Motors ein, erregt ihn und wird dort in Wärme umgesetzt. Deshalb ist eine solche Bewegungsbahn unerwünscht.

Im Fall einer parallel zur Richtung der Funktionsfläche 5 extrem langgezogenen Ellipse (nicht dargestellt) wäre die senkrecht zur Rotoroberfläche gerichtete Energie für einen Friktionskontakt von Oszillator 2 mit Rotor 6 nicht ausreichend. Bei solchen Motoren würde ein großer Teil der Energie als Wärme u.a. im Oszillator 2 freigesetzt werden. Deshalb hat im erfindungsgemäßen Motor der Oszillator 2 optimale Abmessungen, die durch die Bewegungsbahnen der Punkte vorgegeben sind. Diese Abmessungen werden durch das Verhältnis von Länge der erzeugten Stehwelle $\lambda$ zur Höhe h des Oszillators 2 (Wellenleiter 3) bestimmt. Der genaue Wert des optimalen Verhältnisses hängt von den Elastizitätseigenschaften des Oszillatormaterials 2 und von seiner Breite b ab und befindet sich im Bereich von $\lambda$ bis $0,25\,\lambda$.

Unabhängig voneinander erzeugen die Stehwellengenerator 9, 10, 11 im Oszillator 3 akustische Stehwellen, so daß jeder dieser Generatoren als ein unabhängiges elektromechanisches Schwingungssystem betrachtet werden kann. Deshalb kann man für jeden der Generatoren 9, 10, 11 auf dem Oszillator 2 ein Elementarvolumen der Länge $\lambda$ mit einem Stehwellengenerator, wie in Fig. 13, Position 34 gezeigt, herauslösen. Ein solches Volumen kann als elementares unabhängiges Schwingungssystem der Länge $\lambda$ mit Elektroden der Länge $\lambda/2$, d. h. als ein zweimodiger piezoelektrischer Resonator betrachtet werden (Fig. 13, Position 35). Das elektrische Ersatzschaltbild eines solchen Resonators ist in Fig. 13, Position 36 dargestellt. Die Schaltung enthält folgende Bauteile:

- eine statische Kapazität

$$C_o = s/b \cdot \varepsilon_{33}{}^T (1-K_{31}{}^2),$$

wobei s die Fläche der Elektroden bedeutet.
- einen idealen elektromechanischen Wandler mit einem Wandlungskoeffizienten von

$$N_p = b/2 \cdot d_{31}/S_{11}{}^E$$

- eine mechanische Kapazität

$$C_M = \lambda/\pi^2 \cdot S_{11}{}^E/b \cdot h$$

- eine mechanische Induktivität

$$L_M = m,$$

wobei m die Masse des Elementarvolumens darstellt.
- einen Widerstand für die mechanischen Verluste im Oszillator

$$R_M = \omega L_M/\theta_{e.G.},$$

wobei $\theta_{e.G.}$ die effektive Güte des Motors darstellt.

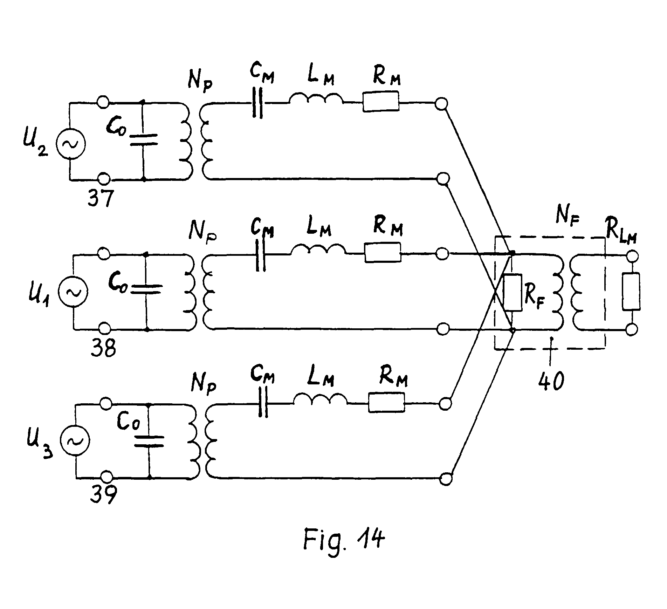

Das vollständige Ersatzschaltbild eines Wanderwellengenerators 4 kann als eine Einheit von drei identischen Ersatzschaltbildern 37, 38, 39 (Fig. 14) der drei Stehwellengeneratoren 9, 10, 11 betrachtet werden. In der vollständigen Schaltung ist jedes der Ersatzschaltbilder 37, 38, 39 mit seiner Erregerquelle 17, 18, 19 verbunden. Der Ausgang jedes der Ersatzschaltbilder 37, 38, 39 ist mit dem Friktionswandler 40 verbunden. Der im kompletten Ersatzschaltbild angegebene Friktionswandler 40 spiegelt den Friktionskontakt des erfindungsgemäßen piezoelektrischen Motors wieder. Er enthält einen Widerstand für die Reibungsverluste im Friktionskontakt $R_F$ und einen idealen Wandler, der die Schwingungsbewegung des Oszillators 2 in eine Drehbewegung des Rotors 6 umwandelt, wobei für den Transformationskoeffizienten gilt:

$$N_F = M/F_\sim,$$

mit

M für das konstante Drehmoment,
$F_\sim$ für eine veränderliche Kraft.

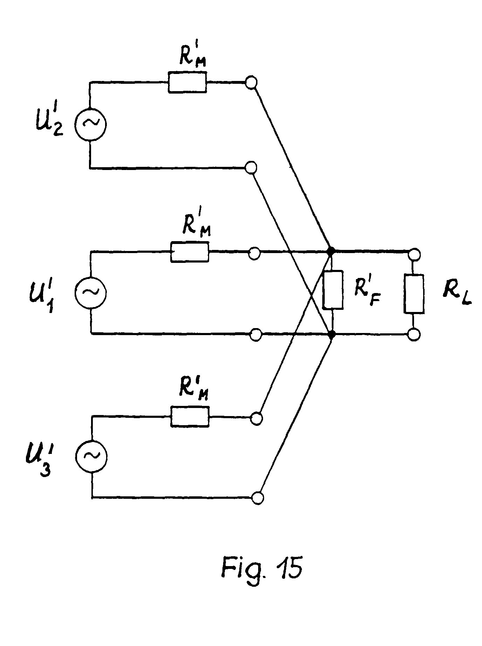

Der Ausgang des Friktionswandlers 40 ist mit dem Widerstand der mechanischen Last $R_L$ verbunden. Das in Fig. 14 dargestellte Ersatzschaltbild kann bei Annahme, daß der piezoelektrische Motor bei der mechanischen Resonanzfrequenz des Oszillators 2 arbeitet, in ein einfacheres Ersatzschaltbild gemäß Fig. 15 umgewandelt werden. In diesem Ersatzschaltbild sind die Parameter $U_1'$, $U_2'$, $U_3'$, $R_M'$, $R_F'$ auf die mechanische Seite der Schaltung gemäß Fig. 14 überführt worden.

EP 0 789 937 B1

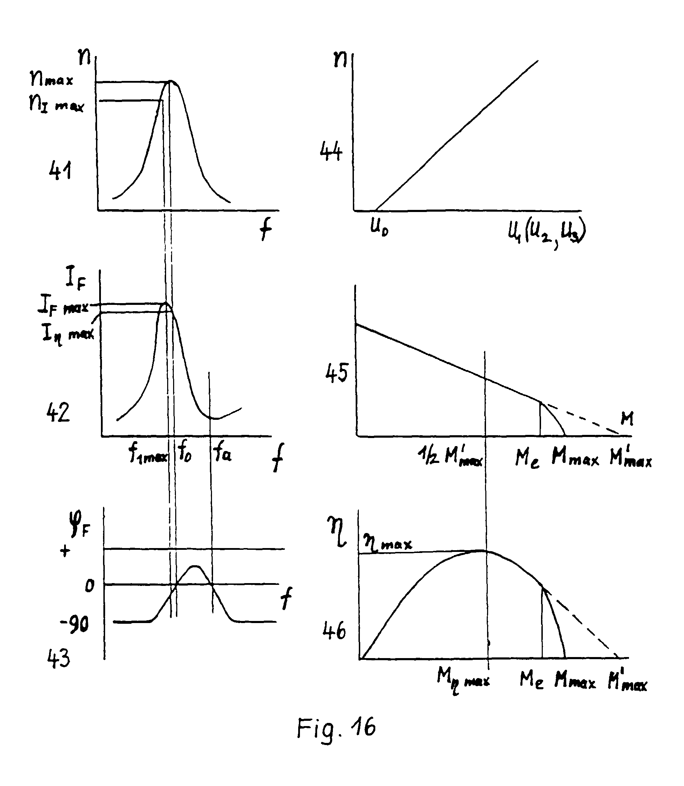

Der erfindungsgemäße Motor weist die klassischen elektromechanischen Eigenschaften von piezoelektrischen Motoren auf. In den praktischen Ausführungen ist der Widerstand $R_M$ für die mechanischen Verluste im Oszillator immer bedeutend kleiner als der Blindwiderstand $\omega L_M$ des Oszillators 5. Deshalb hat die Frequenzabhängigkeit des Motors die in Fig. 16, Positionen 41, 42, 43 gezeigte Form. Position 41 stellt die Abhängigkeit der Drehfrequenz $\eta$ von der Erregerfrequenz f, Position 42 die Abhängigkeit des Phasenstroms $I_F$ (Strom eines der Stehwellengeneratoren 9, 10, 11) von der Erregerfrequenz f und Position 43 die Abhängigkeit der Phasenverschiebung $\varphi$ zwischen der Erregerspannung $U_1$ ($U_2$, $U_3$) und dem Phasenstrom $I_F$ von der Erregerfrequenz f dar.

Alle Kennwerte nach 41, 42, 43 sind über charakteristische Punkte miteinander verknüpft. So entspricht das Maximum der Drehfrequenz $\eta_{max}$ der mechanischen Resonanzfrequenz des Oszillators $f_0(\omega_0)$. Dieser Frequenz entspricht eine Nullphasenverschiebung (Position 43) zwischen Eingangsspannung $U_1$ ($U_2$, $U_3$) und Eingangsstrom $I_F$ von jeder der Phasen. Das Strommaximum $I_{Fmax}$ der Phase befindet sich bei der Frequenz $f_{Imax}$, welche links von der mechanischen Resonanzfrequenz $f_0$ liegt. Die Stromabhängigkeit 42 weist bei der Anti-Resonanzfrequenz $f_a$ des Oszillators 6 eine zweite Nullphase auf. Die Phasenverschiebung zwischen den Eingangsspannungen $U_1$ ($U_2$, $U_3$) und dem Phasenstrom $I_F$ (43) ist im Bereich von $f_0$ bis $f_a$ positiv. Im verbleibenden Erregerfrequenzbereich ist sie negativ. Alle drei Abhängigkeiten sind stetig, d.h. sie haben keine Bereiche mit nichtdefinierten Zuständen.

In der Position 44, Fig. 16 ist eine Abhängigkeit einer Steuerspannung dargestellt, d.h. die Abhängigkeit der Drehfrequenz $\eta$ von der Höhe der Erregerspannung $U_1$ ($U_2$, $U_3$) bei Betrieb des Motors auf der mechanischen Resonanzfrequenz $f_0$. Praktisch verläuft diese Abhängigkeit linear. Sie weist dann einen kleinen Sprung bei der Spannung $U_0$ auf, wenn die Queramplitude der Schwingung des Oszillators 2 kleiner als die Unebenheiten der Funktionsfläche 5 sind.

In der Position 45, Fig. 16 sind die mechanischen Kennwerte des erfindungsgemäßen Motors, die Abhängigkeit der Drehfrequenz $\eta$ vom Lastmoment M bei Betrieb des Motors auf der mechanischen Resonanzfrequenz $f_0$ dargestellt. Bis zum Lastmoment $M_e$ ist die Abhängigkeit linear. Dieses Moment bedeutet Abriß des Friktionskontaktes. Im Lastbereich von $M_e$ bis $M_{max}$ arbeitet der Motor unregelmäßig. Durch die gerissene Linie ist der maximal mögliche lineare Wert des Lastmoments $M'_{max}$ angegeben. Dieser Wert kann bei idealer Auswahl der Werkstoffe für das Friktionspaar aus Stator 11 und Rotor 6 erreicht werden. Position 46, Fig. 16 zeigt das Gütediagramm des Motors; das ist die Abhängigkeit des Wirkungsgrades $\eta$ vom Lastmoment M bei Betrieb des Motors auf der mechanischen Resonanzfrequenz $f_0$. Bis zum Lastwert $M_e$ hat die Abhängigkeit die Form einer Parabel. Das Maximum befindet sich in der Nähe des halben maximal möglichen Lastmoments $1/2\ M'_{max}$. Die Höhe des maximalen Wirkungsgrades $\eta_{max}$ hängt vom Verhältnis des Verlustwiderstandes $R'_M$ des Oszillators zum Verlustwiderstand des Friktionskontaktes $R'_F$ ab. In der praktischen Realisierung ist der Verlustwiderstand des Friktionskontaktes $R'_F$ immer größer als der Verlustwiderstand des Oszillators $R'_M$. Deshalb hat der erfindungsgemäße Motor einen ausreichend großen Wirkungsgrad, der im Bereich von 30 - 70 % liegt.

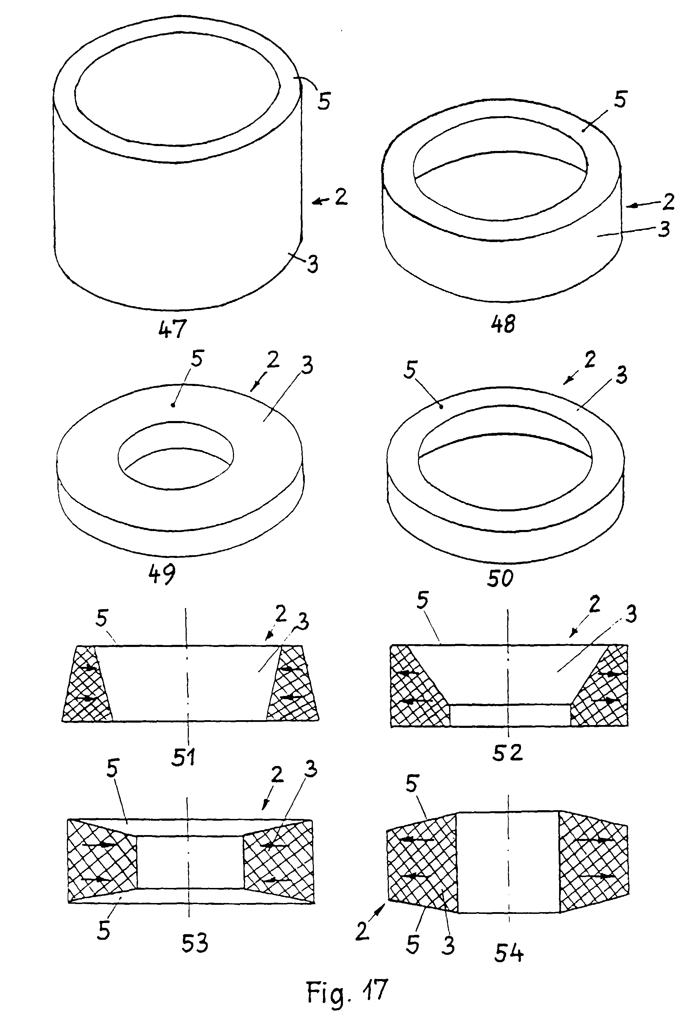

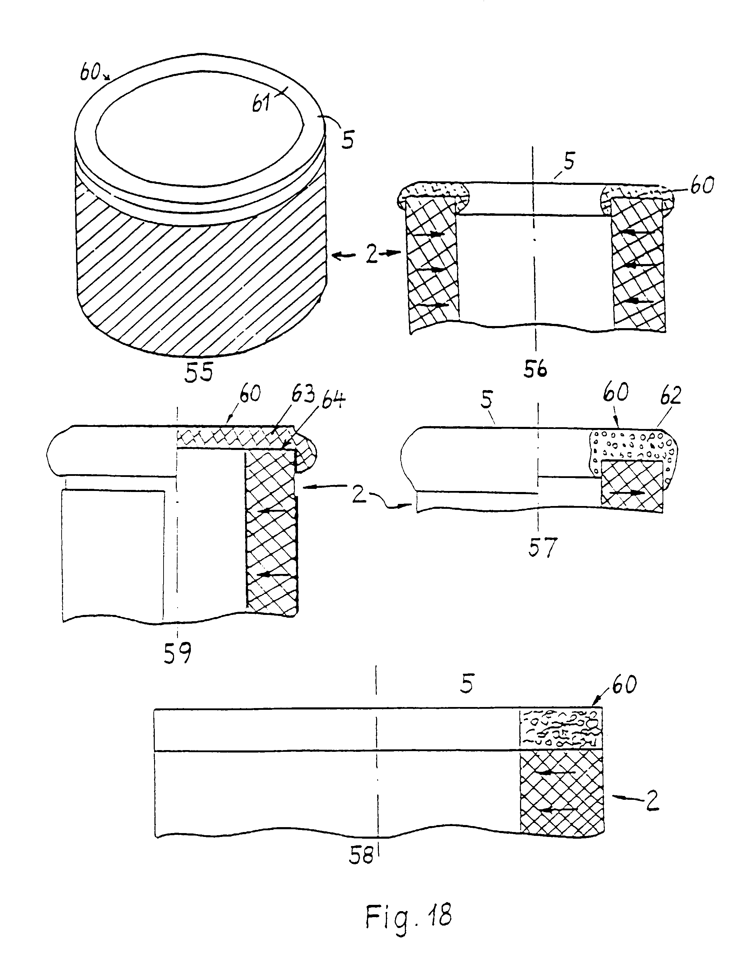

In der Fig. 17 sind einige Varianten 47 bis 54 von vollständig aus Piezokeramik gefertigten monolithischen Oszillatoren 2 des erfindungsgemäßen Motors dargestellt. Diese Oszillatoren sind die Wellenleiter für die vom Generator 4 erzeugte Wanderwelle. Jede der dargestellten Varianten kann in Abhängigkeit von der konkreten Konstruktion und den geforderten Motorparametern verwendet werden. So ermöglicht z.B. der als langgezogener Zylinder ausgeführte Oszillator 2, dessen Höhe gleich oder größer als sein Durchmesser ist (Position 47), den Aufbau von piezoelektrischen Motoren minimaler Abmessungen mit einem Wanderwellengenerator 4 (Fig. 1). Der Oszillator 2 als kurzer, breiter Zylinder (Position 48) wird dann verwendet, wenn maximale mechanische Leistungen gefordert werden. In dem Fall kann man den Durchmesser des Oszillators 2 unbegrenzt vergrößern, dadurch wird die Zahl der Wanderwellengeneratoren 4 und entsprechend die Zahl der mit dem Rotor 6 in Kontakt tretenden Wellen vergrößert. Ein Oszillator in Scheibenform (Position 49), der ebenfalls als Zylinder angesehen werden kann, kann für einen flachen Motor, der nur eine minimale Höhe hat, eingesetzt werden. In dem Fall, wenn ein piezoelektrischer Motor mit minimalen Querschnitt und einer Öffnung im Zentrum erforderlich ist, wird ein Oszillator in Form eines zylindrischen Ringes (Position 50) eingesetzt. Die Verwendung eines Oszillators mit konischer Querschnittsform (Position 51, 52) gestattet eine Vervielfachung der Schwingungsgeschwindigkeit. Solche Oszillatoren funktionieren ähnlich wie Konzentratoren für mechanische Spannungen, die die Schwingungsgeschwindigkeit in einem kleinen Bereich ihres Querschnitts vervielfachen. Die Verwendung von vervielfachenden Konzentratoren ermöglicht es, die Schwingungsgeschwindigkeit um das 1,5 - 2fache zu erhöhen und folglich auch die Drehfrequenz des Rotors. Die Positionen 53, 54 zeigen Oszillatoren mit konischer Funktionsfläche 5. Solche Oszillatoren ermöglichen es, piezoelektrischen Motoren ohne zentrierende Kugellager aufzubauen, was wesentlich die Motorkosten verringert. Da die konische Funktionsfläche 5 des Oszillators 2 eine große Fläche bildet, erhöht sich proportional dazu die mechanische Leistung des Motors. Der erfindungsgemäße piezoelektrische Motor beruht auf einem Friktionskontakt von Oszillator 2 und Rotor 6, d.h. die aufeinander einwirkenden Flächen unterliegen einem Friktionsverschleiß. Der Verschleißgrad dieser Oberflächen bestimmt die Funktionsdauer (Standzeit) des Motors und hängt von der Verschleißfestigkeit der eingesetzten Werkstoffe für die Friktionspaarung von Funktionsfläche 5 des Oszillators 2 und Oberfläche des Rotors 6 ab. Die Auswahl des Rotorwerkstoffes stellt keine besonderen Probleme dar. Er kann sowohl aus sehr harten Werkstoffen wie Keramik auf der Basis von Aluminiumoxid, Zirkoniumoxid, Titankarbid, Wolframkarbid, legierten und wärmebehandelten Stahl u.ä. gefertigt werden als auch aus

9

weichen zusammengesetzten Friktionswerkstoffen auf der Basis von wärmereaktiven Plasten mit festen Füllstoffen. Die Auswahl des Oszillatorwerkstoffes ist schwieriger, da der Oszillator aus piezoaktiven Material gefertigt werden muß. Direkt als Werkstoff für den Friktionskontakt ist nur eine begrenzte Zahl von piezoaktiven Werkstoffen einsetzbar. Das sind Quarz, einige andere Monokristalle und Bariumtitanat. Quarz hat einen sehr kleinen Piezomodul, was seine Verwendung einschränkt. Bariumtitanat besitzt einen niedrigen Curie-Punkt, was einem Einsatz in einem großen Temperaturbereich widerspricht. Die Frage des Einsatzes eines breiten Spektrums von Piezokeramik im erfindungsgemäßen Motor ist dadurch gelöst worden, daß die Funktionsfläche 5 des Oszillators 2 mit einer dünnen abriebfesten Schicht versehen ist, die dem Friktionsverschleiß des Oszillators 2 entgegenwirkt und gleichzeitig den Reibungskoeffizienten der Funktionsfläche 5 bestimmt. Der Werkstoff für die Friktionsschicht 5 muß folgenden Forderungen entsprechen: Er muß widerstandsfähig gegenüber dem Friktionsverschleiß aufgrund der Friktionswirkung Oszillator - Rotormotor sein; er muß eine feste, z.B. chemische Verbindung, mit der Piezokeramik eingehen. Er muß außerdem widerstandsfähig gegenüber starken Ultraschallfeldern sein. In der Fig. 18 ( Positionen 55, 56, 57, 58, 59 ) sind einige Varianten einer abriebfesten Schicht 60 des erfindungsgemäßen piezoelektrischen Motors dargestellt. Gemäß Position 55 kann die abriebfeste Schicht ein 0,1 - 0,3 mm dünner, aus Oxidkeramik (Basis Aluminiumoxid oder anderer Werkstoff) gefertigter Ring 61 sein, der auf den piezoelektrischen Oszillator 2 mit einem Material, das eine chemische Verbindung mit der Oxidkeramik und der Piezokeramik eingeht, z.B. Glas, geklebt ist. Ein solches Glas muß eine ausreichende Menge Bleioxid enthalten. In der Position 56 ist eine Variante einer abriebfesten Schicht 60 dargestellt, welche im gegebenen Fall eine dünne Schicht eines harten abriebfesten und auf die Funktionsfläche 5 des Oszillators 2 aufgetragenen Glases darstellt. Das Glas wird vor der Polarisation auf den Oszillator 2 aufgebracht. Damit das Glas bei der Abkühlung nicht splittert, muß es entsprechend dem Temperaturausdehnungskoeffizienten ausgewählt werden, und zwar so, daß dieser Koeffizient sich nicht um mehr als 5 % vom Temperaturausdehnungskoeffizienten der Piezokeramik unterscheidet. Solche Schichten werden für Motoren kleiner Leistung eingesetzt.

Die Verwendung einer Friktionsschicht aus reinen Glas hat den Nachteil, das die Gläser einen sehr kleinen Reibungskoeffizienten haben. Zur Erhöhung des Reibungskoeffizienten kann das Glas mit einem Pulver 62 aus einem abrasiven Materials versetzt werden (Position 57 der Fig. 18). Als abrasiver Füllstoff können Pulver aus Alluminiumoxid, Titankarbid, Titannitrid o.ä. verwendet werden. In einer solchen Ausführungsvariante kann der Wellenwiderstand der Friktionsschicht 60 genau ausgewählt werden, was sie für die Ultraschallwellen nicht unterscheidbar macht, d.h. die Sicherheit der Verbindung wird erhöht und damit die Leistung des Motors gesteigert.

Besonders feste Friktionsschichten für piezokeramische Leistungsmotoren im Schrittbetrieb können aus poröser Oxidkeramik, angefüllt mit einen, eine Verbindung mit der Piezokeramik des Oszillators 2 eingehenden Material, hergestellt werden. Eine solche Friktionsschicht 60 zeigt die Position 58, Fig. 18. Hierfür ist eine poröse Aluminiumoxidkeramik gut geeignet, deren Poren mit einem leichtschmelzenden und eine chemische Verbindung mit der Piezokeramik des Oszillators 2 eingehenden Glas aufgefüllt werden.

In der Fig. 18, Position 59 ist eine Ausführungsvariante der Friktionsschicht 60 als Doppelschichtstruktur mit einer Grundschicht 63 und einer Zwischenschicht 64 dargestellt. In dieser Variante bestimmt die Grundschicht die Friktionseigenschaften der Funktionsfläche 5, und die Zwischenschicht 64 bildet eine feste Verbindung zwischen Piezokeramik und Oszillator 2. Es ist technologisch sinnvoll, die Zwischenschicht 64 als Metallschicht aufzutragen, die gleichzeitig die Struktur der Elektroden 15, 16 des Oszillators 2 bildet. Eine solche Deckschicht kann durch chemisches Abscheiden von Nickel, durch Sputtern von Nickel, Tantal oder eines anderen Materials mittels Ionenimplantation erzeugt werden. Die Grundschicht 63 aus Chrom oder einem anderen festen Material kann auf die Zwischenschicht 64 im Bereich des Friktionskontaktes mittels eines chemischen oder elektrochemischen Verfahrens aufgetragen werden. Die vorgeschlagene Erfindung kann auch andere geeignete Verfahren zur Bildung der Friktionsschicht 60 nutzen.

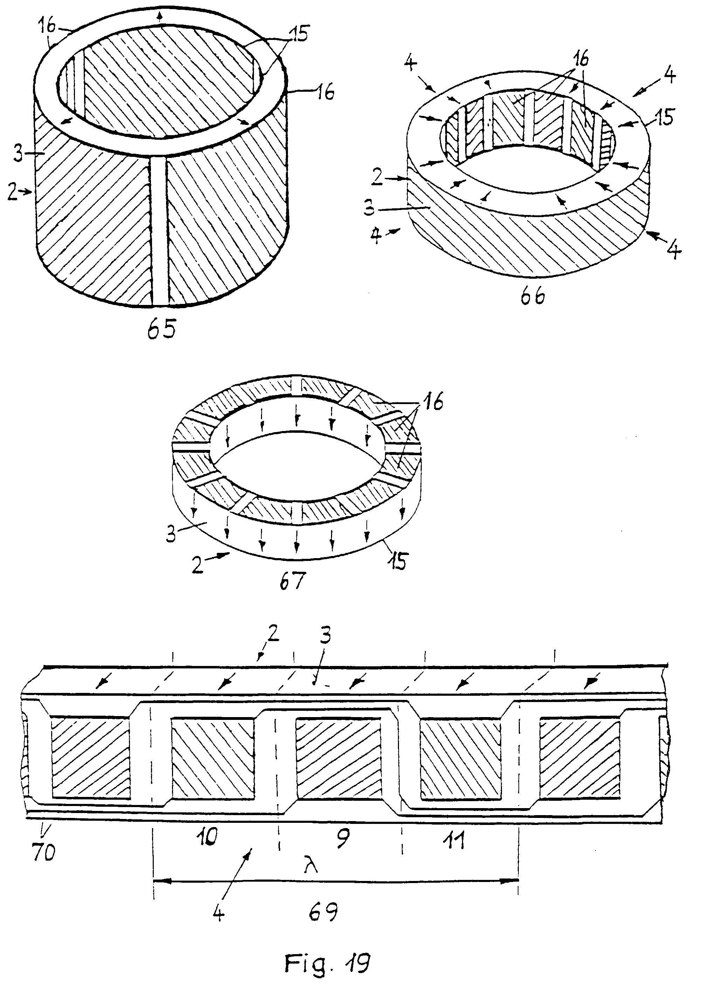

Jede Variante des Oszillators 2 für den erfindungsgemäßen piezoelektrischen Motor enthält eine Anzahl von Wanderwellengeneratoren 4, die praktisch sein gesamtes Volumen ausfüllen. Diese Generatoren legen die Struktur der Elektroden 15, 16 auf der Oberfläche des Wellenleiters 3 des Oszillators 2 fest. Fig. 19 zeigt anhand der Positionen 65 bis 69 die wichtigsten Ausführungsvarianten für die Elektroden 15, 16. In der Position 65 sind ein Oszillator 2 mit einem Generator 4 und nachfolgend drei Gruppen von Elektroden 15, 16 abgebildet. Jede dieser Elektrodengruppe bildet einen Stehwellengenerator 9, 10, 11 (Fig. 1). Position 66 zeigt einen Oszillator 2 als kurzen Zylinder. Dieser Oszillator verfügt über vier Wanderwellengeneratoren 4. Alle Elektroden 15 dieses Oszillators bilden nach außen eine gemeinsame Elektrode. Die getrennten Elektroden 16 befinden sich auf der Innenfläche des Oszillators 2. In der Position 67 ist der Oszillator 2 als Ring mit auf seinen ebenen Flächen angeordneten Elektroden 15, 16 gezeigt. Die streifenförmigen Elektroden 15, 16 können auch nur auf der Außenfläche oder Innenfläche des Oszillators 2 vorgesehen sein. Ein derartiger Oszillator kann bei einer Anregung des Oszillators mit hoher Spannung eingesetzt werden. Position 69 der Fig. 19 zeigt einen abgewickelten Oszillator 2 mit einer Variante für die Elektroden 15, 16, bei der alle Verbindungen zwischen den Elektroden als Leitungen 70 ausgeführt sind. Eine solche Struktur kann auf photochemischen Wege hergestellt werden.

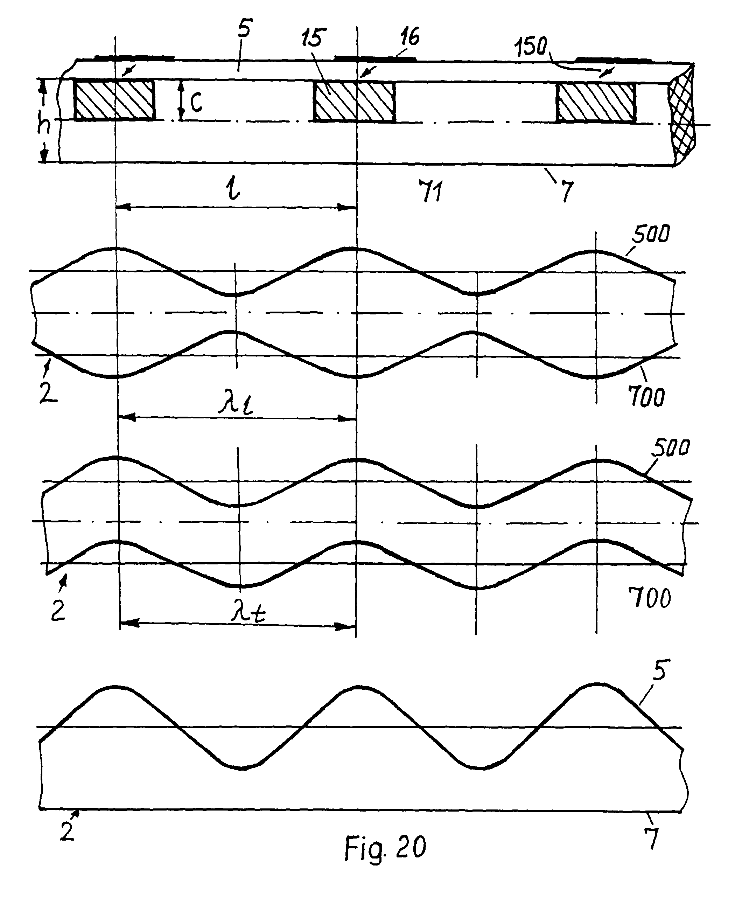

Die Erfindung sieht eine besondere Konfiguration für die Elektroden jedes Stehwellengenerators 9, 10, 11 vor (Fig. 20, Position 71). In dieser Ausführungsvariante haben die Elektroden 15, 16 eine Höhe c, die etwa gleich der halben Höhe h des Oszillators 2 ist, und einen Abstand 1 voneinander. In diesem Fall wird gleichzeitig mit der Longitudinalwelle 500 eine elastische Welle 700 erzeugt. Die Amplitudenhöhen von Longitudinalwelle und elastischer Welle können durch Ändern der Höhe der Elektroden 15, 16 verändert werden. Die Länge $\lambda_t$ der elastischen Welle hängt von der Oszillatorhöhe h ab. Die Höhe c der Elektroden 15, 16 bestimmt das Verhältnis der Amplituden von Longitudinalwelle und elastischer Welle zueinander. Deshalb sind durch Variation der Höhe c der Elektroden 15, 16 und der Höhe h des Oszillators 2 solche Werte eingestellt worden, bei denen die Amplitude und die Länge $\lambda_t$ der elastischen Welle 700 gleich der Amplitude und der Länge $\lambda_1$ der Longitudinalwelle 500 ist, siehe Wellendiagramm der Fig. 20. Dabei hängt die Länge $\lambda_1$ der Longitudinalwelle von der Länge des Oszillators 2 ab und ist von der Höhe h der Elektroden 15, 16 unabhängig. Bei gleichzeitiger Erzeugung dieser zwei Wellen im Oszillator 2 überlagern sich die von ihnen bedingten Verformungen. Fig. 20 zeigt unten die Gesamtverformung des Oszillators 2. Daraus ist erkennbar, daß die Amplitude der überlagerten Welle der Funktionsfläche 5 gleich der doppelten Amplitude der Longitudinalwelle ist und daß auf der Stirnfläche 7 sich die Längs- und die elastischen Verformungen gegenseitig kompensieren, d.h. diese Stirnfläche 7 wird nicht verformt, es entsteht keine Welle.

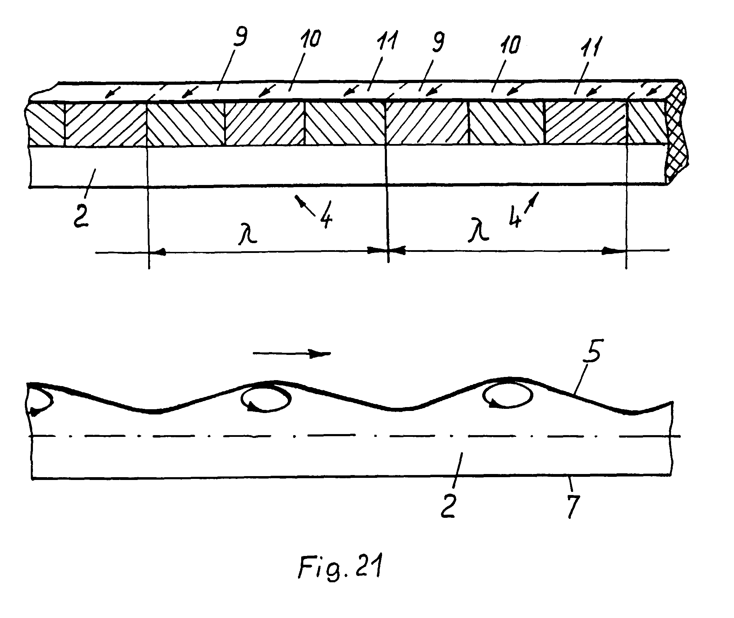

Offensichtlich ist, daß bei Erzeugung von drei Stehwellen im Oszillator 2 durch die drei Generatoren 9, 10, 11 (Position 72, Fig. 21), analog zu dem in Position 71, Fig. 20 dargestellten Generator, im Oszillator 2 eine unsymmetrische Wanderwelle erzeugt wird, und zwar so, wie in Fig. 21 dargestellt. Diese Welle verformt die Funktionsfläche 5, die Stirnfläche 7 wird dabei nicht verformt. In dieser Variante eines piezoelektrischen Motors wird die Energie des Oszillators 2 nicht von der schallisolierenden Unterlage 8 aufgenommen. Deshalb haben solche Motoren einen potentiell höheren Wirkungsgrad.

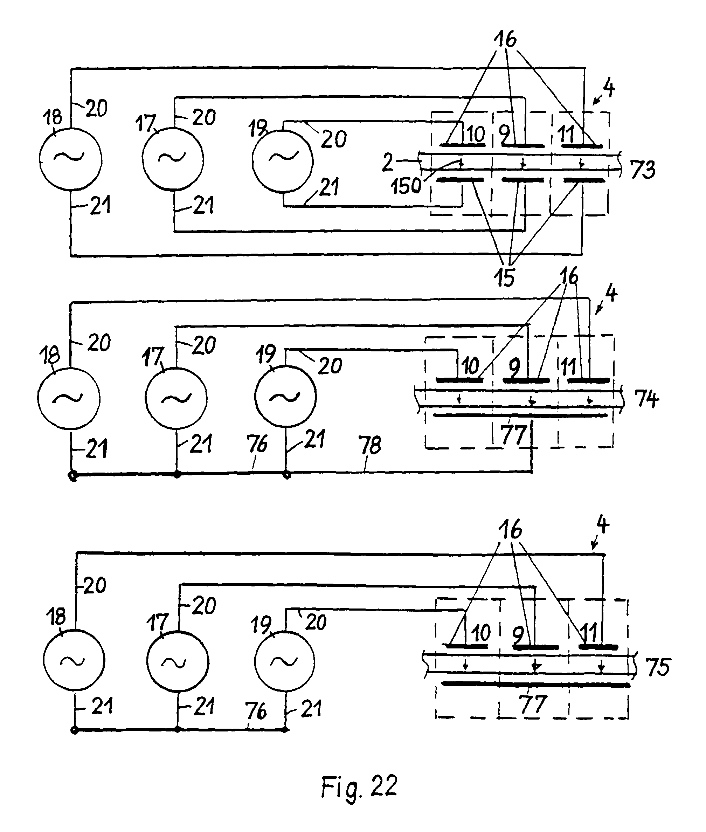

Die Erfindung sieht verschiedene Varianten zur Ansteuerung der Stehwellengeneratoren 9, 10, 11 mittels der Erregerquellen 17, 18, 19 vor. In der Fig. 22 mit den Positionen 73, 74, 75 sind die das allgemeine Erregerprinzip illustrierenden Schaltungen zur Verbindung der Erregerquellen 17, 18, 19 mit den Generatoren 9, 10, 11 dargestellt.

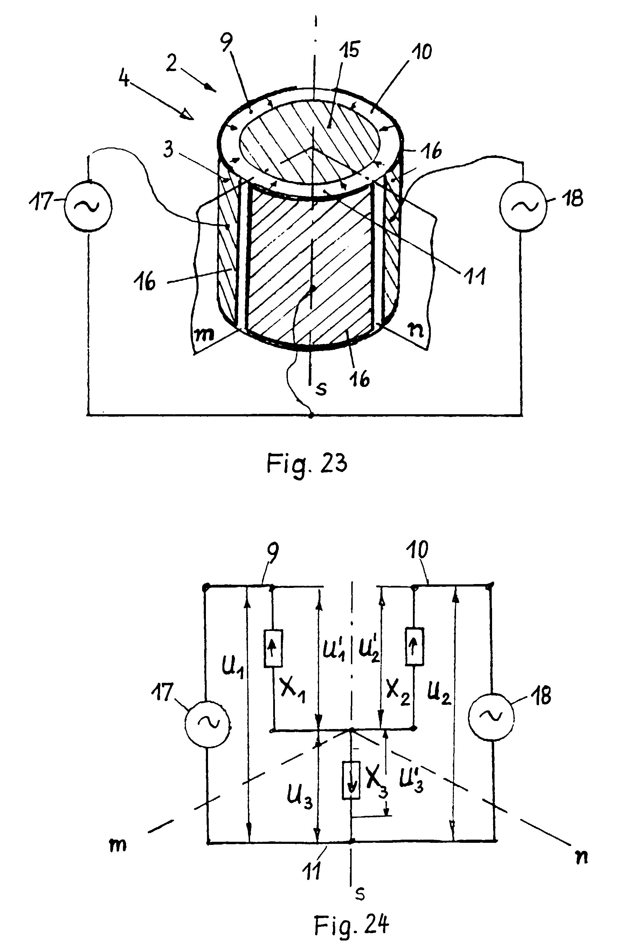

Die Schaltung nach Position 73 veranschaulicht die Fremderregung der Generatoren 9, 10, 11 durch die Quellen 17, 18, 19. Es ist offensichtlich, daß diese Schaltung in das Schaltbild nach Position 74 umgewandelt werden kann, wo alle Anschlüsse 21 der Quellen 17, 18, 19 in einem Sammelleiter 76 vereinigt sind und alle Elektroden 15 der Generatoren 9, 10, 11 durch eine gemeinsame Elektrode 77 ersetzt sind. Der Sammelleiter 76 und die gemeinsame Elektrode 77 sind über einen Verbindungsleiter 78 miteinander verbunden. Eine solche Abwandlung ändert das allgemeine Erregerprinzip nicht, läßt aber eine Vereinfachung der Schaltung zu. Außerdem kann man, da die Quellen 17, 18, 19 in Amplitude und Frequenz gleiche elektrische Spannungen, die zueinander in der Phase um $2\pi/3$ (120°) verschoben sind, bereitstellen, und da die elektrischen Widerstände der Generatoren 9, 10, 11 untereinander gleich sind, fließt folglich durch den Verbindungsleiter 78 kein Strom und man kann ihn gemäß Position 75 weglassen. Das bedeutet, daß die gemeinsame Elektrode 77 keinen elektrischen Anschluß zu haben braucht. Eine weitere Vereinfachung der Erfindung ist entsprechend Fig. 23 möglich, aus der der Oszillator 2 mit dem Wanderwellengenerator 4 erkennbar ist. Es sind wieder die drei Stehwellengeneratoren 9, 10, 11 dargestellt, von denen 9 der Grundgenerator und 10 und 11 die Zusatzgeneratoren für die Stehwellenerzeugung sind. Während jedoch die Generatoren 9 und 10 direkt an die Spannungsquellen 17, 18 angeschlossen sind, ist der Generator 11 nur in Verbindung mit den Generatoren 9, 10 an Spannung gelegt. Man kann daher den Generator 11 als zwischen zwei Flächen m, n liegendes gemeinsames Teil der Generatoren 9, 10 ansehen, das entlang einer Fläche s aufgetrennt ist und von dem der Teil, der sich zwischen den Flächen m und s befindet, zum Generator 9 und der Teil, der sich zwischen den Flächen s und n befindet, zum Generator 10 gehört.

Die Elektroden 15, 16 der Generatoren 9, 10, 11 sind mit den Erreger- oder Spannungsquellen 17, 18 verbunden, sie werden von diesen mit Spannungen $U_1$, $U_2$ versorgt. In dem durch Fig. 24 dargestellten elektrischen Ersatzschaltbild sind $X_1$, $X_2$, $X_3$ die Impedanzwiderstände jedes der Teile der Generatoren 9 und 10. Wenn die Abschnitte der Generatorteile 9 und 10 untereinander gleich sind, sind auch die Impedanzwiderstände $X_1$, $X_2$, $X_3$ gleich. Entsprechend der Erfindung muß der Phasenwinkel zwischen den Spannungen $U_1$, $U_2$, $U_3$ ±120° betragen oder in der Nähe dieses Wertes liegen. In dieser Ausführungsform werden die an den Oszillator 2 angelegten Spannungen $U_1$, $U_2$ durch die Teiler $X_1$, $X_2$, $X_3$ geteilt und die so erhaltenen Teile an $X_3$ aufsummiert. Als Ergebnis erscheinen an jedem Teil des Oszillators 2 die Spannungen $U_1'$, $U_2'$, $U_3'$. Wenn $X_1 = X_2 = X_3$ ist, ist $U_1' = U_2'$. Die Spannung $U_3'$ ist etwas kleiner als $U_1'$ bzw. $U_2'$. Der Phasenverschiebungswinkel $\varphi$ zwischen den Spannungen $U_1$ und $U_2$ beträgt etwa 120°. Der Phasenwinkel zwischen den Spannungen $U_1'$ bzw. $U_2'$ und $U_3'$ ist etwa gleich $\varphi/2$. Da das gemeinsame Teil 11 der Generatoren 9 und 10, bezogen auf den durch sie fließenden Strom, entgegengesetzt zu den getrennten Teilen geschaltet ist, ist die Phase seiner Erregungsspannung um 180° gedreht; d.h. die Phase $\varphi'$ der Spannung $U_3'$, die den zweiten Zusatzgenerator 11 erregt, beträgt 180° - $\varphi/2$; wenn also im speziellen Fall $\varphi$ = 120°, ergibt sich für $\varphi' \cong 180° - 120°/2 \cong 120°$.

Auf diese Weise wird in dieser erfindungsgemäßen Ausführungsvariante die dritte Stehwelle durch das gemeinsame Teil 11 der zwei Stehwellengeneratoren 9 und 10 erregt. Dieses gemeinsame Teil wird durch eine Spannung erregt, die aufgrund der Überlagerung von Teilen der Spannungen $U_1$ und $U_2$ gebildet wird. Deshalb gibt es in dieser Ausführungsform keine Erregerquelle 19, wodurch eine erhebliche Vereinfachung eintritt.

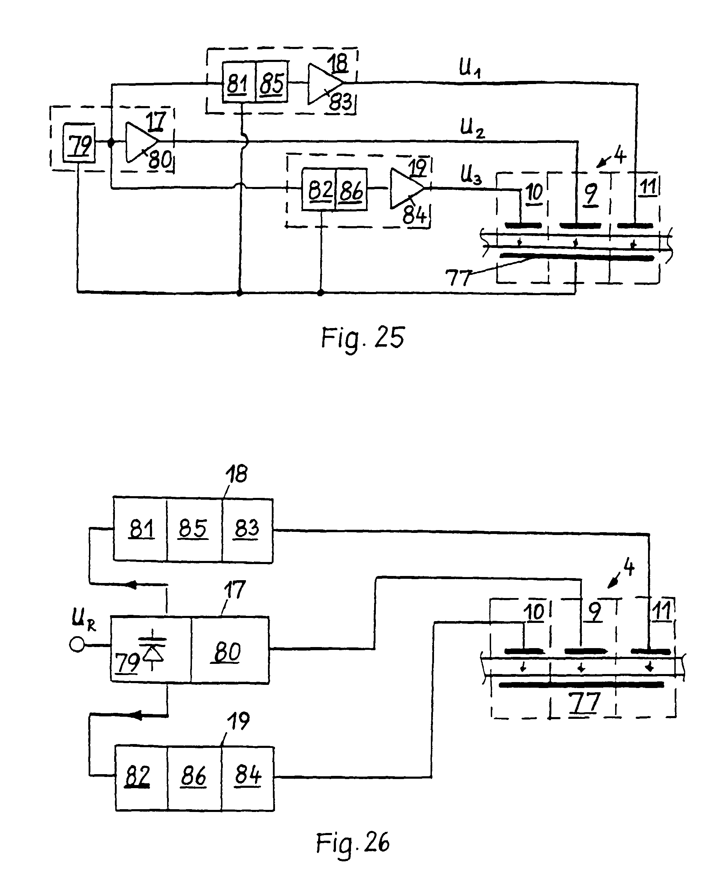

Bei der praktischen Realisierung der vorgeschlagenen Erfindung ist es infolge der Fremderregung der Generatoren 9, 10, 11 schwierig, auf einfache Weise einen Synchron- und In-Phase-Betrieb der Erregerquellen 17, 18, 19 zu gewährleisten. Deshalb sieht die erfindungsgemäße Ausführung gemäß Fig. 25 eine Selbsterregung vor, die am Wesen der Erfindung nichts ändert. Bei einer Selbsterregung der Generatoren 9, 10, 11 stellt die Erregerquelle 17 des Grundgenerators 9 die Quelle für das Stützerregersignal dar und die Erregerquellen 18, 19 dienen faktisch zur Phasendrehung und zur Verstärkung dieses Signals. Dabei schließt die Erregerquelle 17 einen Generator 79 für das elektrische Stützsignal und einen Leistungsverstärker 80 ein, und die Quellen 18, 19 schließen Phasendrehglieder 81, 82 und Pufferverstärker 83, 84 mit ein. Außerdem können die Quellen 18, 19 Vorrichtungen 85, 86 zur Umpolung des Phasenwinkels enthalten.

Eine solche Ausführungsvariante arbeitet nach folgenden Prinzip. Der Generator 79 für das Stützsignal stellt ein elektrisches Signal bereit, dessen Frequenz gleich der mechanischen Resonanzfrequenz $f_0$ des Oszillators 2 ist. Dieses Signal gelangt auf den Verstärker 80 und auf die Phasendrehglieder 81, 82 der Quellen 18, 19. Die Phasendrehglieder drehen die Phase des Signals jeweils um $\pm 2\pi/3$ ($\pm 120°$). Von den Phasendrehgliedern 81, 82 wird das Signal jeder Quelle 18, 19 auf die Vorrichtungen 85, 86 zur Umpolung des Phasenwinkels gegeben. Danach werden die Signale durch die Verstärker 83 und 84 verstärkt. Die durch die Verstärker 80, 83 und 84 verstärkten drei Signale werden als Erregerspannungen der Quellen 17, 18, 19 auf die entsprechenden Stehwellengeneratoren 9, 10, 11 gegeben.

Das Frequenzdiagramm 42 gemäß Fig. 16 des erfindungsgemäßen piezoelektrischen Motors ist stetig, d.h. es hat keine Punkte mit instabilen Zuständen. Deshalb kann sich die Frequenz des Steuergenerators 79 in einem beliebigen Bereich des Frequenzdiagramms 42 befinden. Bei Bedarf ist es deshalb möglich, durch Verändern der Erregerfrequenz die Drehfrequenz des Rotors 6 zu ändern. Mit Hilfe der Vorrichtungen 85, 86 kann durch Umschalten der Phase der Signale von den Quellen 18, 19 in die jeweilige Gegenrichtung (um $\pm 120°$ bezogen auf die Phasenlage des Signals der Quelle 17), die Drehrichtung des Rotors umgekehrt werden.

In Fig. 26 ist eine Ausführungsvariante des erfindungsgemäßen Motors mit einem Steuergenerator 79 als frequenzgesteuerter Autogenerator abgebildet. In einer solchen Ausführungsvariante kann die Drehfrequenz des Rotors 6 durch Ändern der Steuerspannung $U_R$, d.h. durch Ändern der Erregerspannung des Steuergenerators 79, geändert werden.

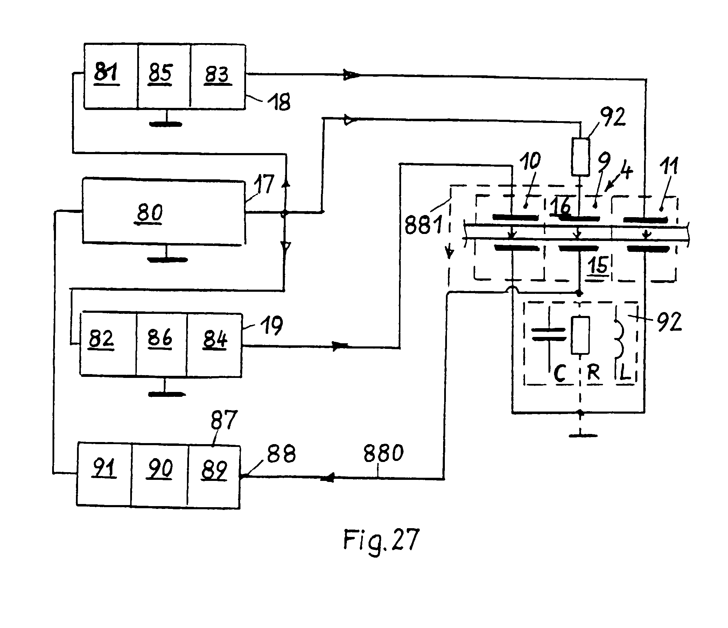

Für viele Verwendungsfälle der vorgeschlagenen Erfindung ist es sinnvoll, daß, wegen aller destabilisierenden Einwirkungen, die Arbeitsfrequenz des Motors gleich oder im wesentlichen gleich der mechanischen Resonanzfrequenz $f_0$ des Oszillators 2 ist. Eine solche Ausführungsvariante ist in Fig. 27 zu sehen. Entsprechend dieser Variante enthält der erfindungsgemäße Motor zusätzlich einen positiven Rückkopplungszweig 87 mit einem Eingang 88, einem Filter 89, einer Phasenschieberkette 90 und einem Verstärker 91. Außerdem enthält die Ausführungsvariante ein in Reihe mit dem Grundgenerator 9 geschaltetes Impedanzelement 92, die Erregerquelle 17, die in diesem Fall nur den Verstärker 80 enthält. Der Eingang 88 des Rückkopplungszweiges 87 ist über einen Leiter 880 mit den Elektroden 15, 16 des im Grundgenerator 9 enthaltenen Impedanzelementes 92 verbunden. Fig. 27 zeigt strichliniert eine zweite Verbindungsmöglichkeit 881 mit Impedanzelement 92. Der Ausgang des Rückkopplungszweiges 87 ist mit dem Pufferverstärker 80 der Quelle 17 verbunden. Das Impedanzelement 92 kann ein Widerstand R, eine Induktivität L oder ein Kondensator C sein. Insgesamt stellt die betrachtete Variante einen elektromechanischen Autogenerator dar, der auf der mechanischen Resonanzfrequenz $f_0$ des Oszillators 2 angeregt wird. Realisiert wird der Autogenerator durch den Grundgenerator 9 und seine Erregerquelle 17 mit dem zusätzlichen Rückkopplungszweig 87, die eine geschlossene elektromechanische Kette bilden. Zur Erregung dieser Kette auf der mechanischen Resonanzfrequenz $f_0$ des Oszillators 2, wird das Phasendiagramm 43 der Fig. 16 des erfindungsgemäßen Motors verwendet, welches bei oder in der Nähe der Frequenz $f_0$ einen Nulldurchgang hat.

Die o.g. geschlossene elektromechanische Kette wird so ausbalanciert, daß ihr Verstärkungsfaktor bei der Frequenz $f_0$ größer als eins ist und die

Phasenverschiebung zwischen Eingangs- und Ausgangssignal bei dieser Frequenz an jeder Unstetigkeitsstelle der Kette gleich Null ist. Dabei wird der Verstärkungsfaktor durch die Verstärker 80, 81, 82 und die Phasenverschiebung durch die Phasenschieberkette 90 vorgegeben. Die Größe der Phasenverschiebung des Signals hängt davon ab, welches Bauelement als Impedanzelement 92 eingesetzt wird. Falls ein Widerstand verwendet wird, muß die Phasenverschiebung nur korrigierend sein und kann im Bereich $\pm 10°$ liegen. Bei Verwendung eines Kondensators C befindet sie sich im Bereich von $+90°$ und bei Verwendung einer Induktivität L liegt sie bei $-90°$.

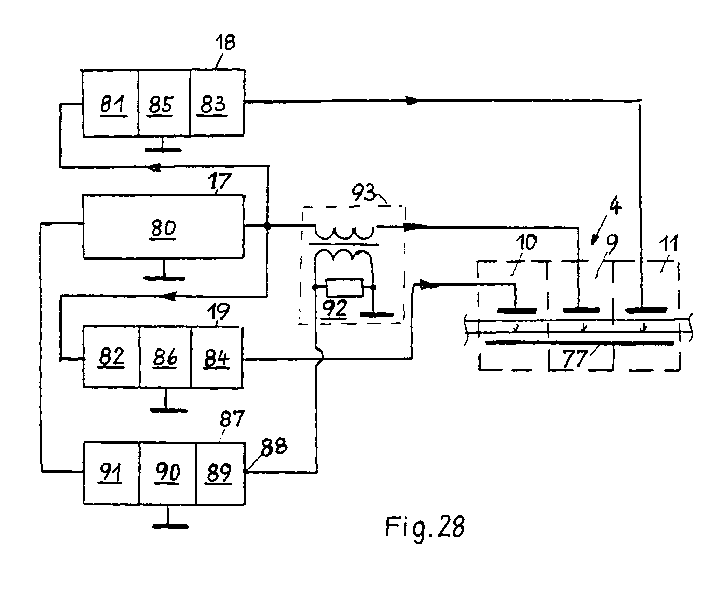

Fig. 28 zeigt eine Ausführungsvariante mit einem Stromwandler 93 im Eingangskreis des Rückkopplungszweiges 87. Diese Variante vereinfacht die Schaltung des elektromechanischen Autogenerators für den Fall, daß der Ausgang der Elektrode 77 fehlt. Insgesamt funktioniert die Vorrichtung analog zur oben betrachteten Fig. 27.

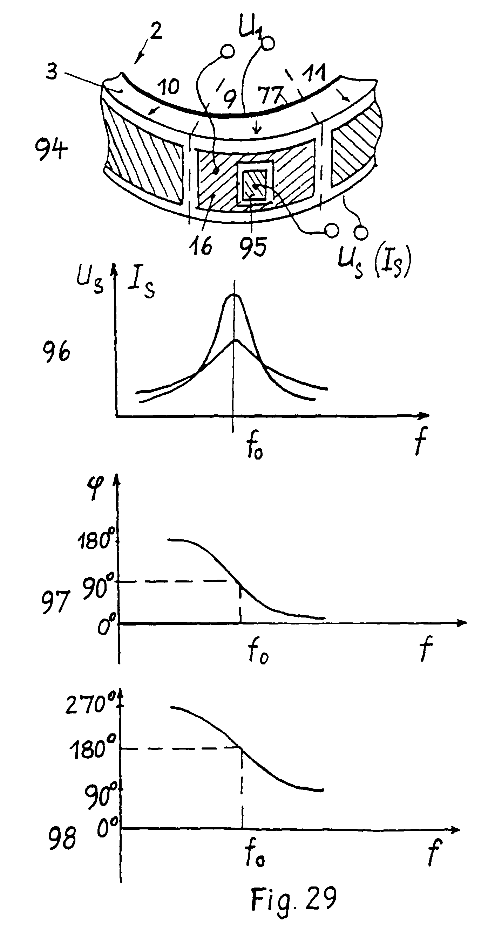

In einigen Anwendungsfällen, in denen es unbedingt erforderlich ist, die Erregerspannung $U_1$ ($U_2$, $U_3$) genauer auf die mechanische Resonanzfrequenz $f_0$ des Oszillators 2 abzustimmen, kann eine Variante verwendet werden, die eine zusätzliche Rückkopplungselektrode 95 enthält (Fig. 29, Position 94). Diese Elektrode 95 befindet sich am Ort des Maximums der mechanischen Spannungen der Stehwelle des Grundgenerators 9. Es sind zwei Funktionsweisen der Elektrode 95 möglich, nämlich Leerlauf und Kurzschlußbetrieb. Im Leerlauf stellt die Elektrode 95 keinen Widerstand für die elektrische Last dar. Bei Erregung des Generators 17 wird aufgrund des direkten piezoelektrischen Effektes auf der Elektrode 95 eine der mechanischen Spannung der Stehwelle des Grundgenerators 9 proportionale Spannung gebildet. Im Kurzschlußbetrieb der Elektrode 95 mit der gemeinsamen Elektrode 77 fließt auf Grund des niedrigen Widerstandswertes ein Kurzschlußstrom. Dieser Strom ist proportional zur mechanischen Spannung der Stehwelle des Grundgenerators 9. Für den elektromechanischen Autogenerator mit der Rückkopplungselektrode 95 werden die Frequenzdiagramme und Phasendiagramme der Leerlaufspannung $U_S$ und des Leerlaufstroms $I_S$ entsprechend den Positionen 96, 97 und 98 verwendet.

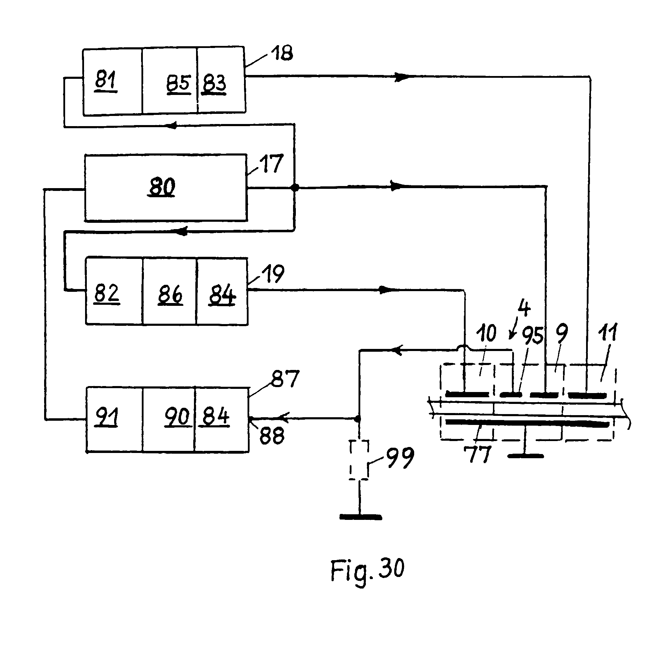

Figur 30 zeigt eine Variante des elektromechanischen Autogenerators mit der Rückkopplungselektrode 95. Die Funktion der Elektrode 95 wird durch einen Widerstand 99 vorgegeben. Die Vorrichtung wird über den Verstärkungsfaktor der Rückkopplung und über die Phasenverschiebung analog zu Fig. 27 ausbalanciert.

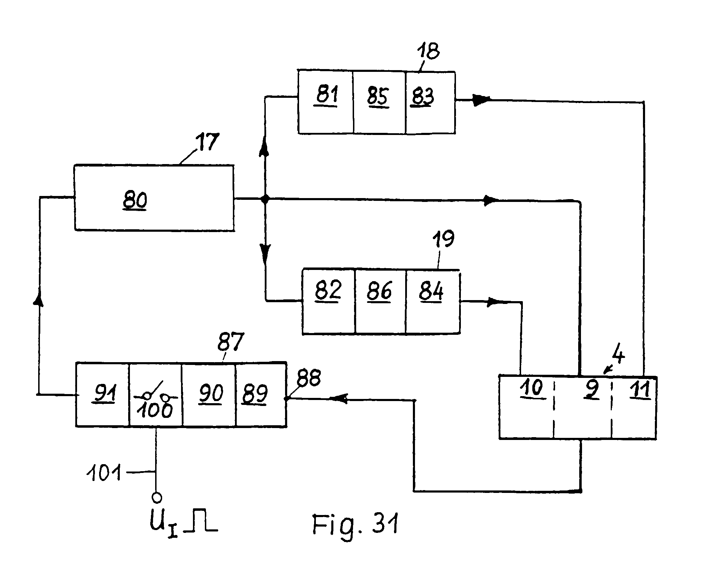

Die vorgeschlagene Erfindung sieht auch die Verwendung eines piezoelektrischen Motors im Schrittbetrieb mit minimaler Start- und Stopzeit vor. Dafür ist gemäß Fig. 31 im Rückkopplungszweig 87 ein Schalter 100 mit einem Steuereingang 101 vorgesehen, der den Stromkreis ein- und ausschaltet. Beim Ausschalten unterbricht oder schließt der Schalter 100 den Signalstromkreis der Rückkopplung kurz. In beiden Fällen wird die Ansteuerung des elektromechanischen Autogenerators bei minimaler Stopzeit des Motors unterbrochen. Beim Einschalten des Rückkopplungszweiges 87 mittels des Schalters 100 wird der Autogenerator beschleunigt gestartet. Die Steuerung durch den Schalter 100 und folglich auch des Schrittbetriebs erfolgt mit einer Impulssteuerspannung $U_I$ beliebiger Dauer.

Im folgenden werden einige mechanische und elektrische konstruktive Ausführungsbeispiele des erfindungsgemäßen piezoelektrischen Motors sowie nicht-erfindungsgemäße Beispiele beschrieben.

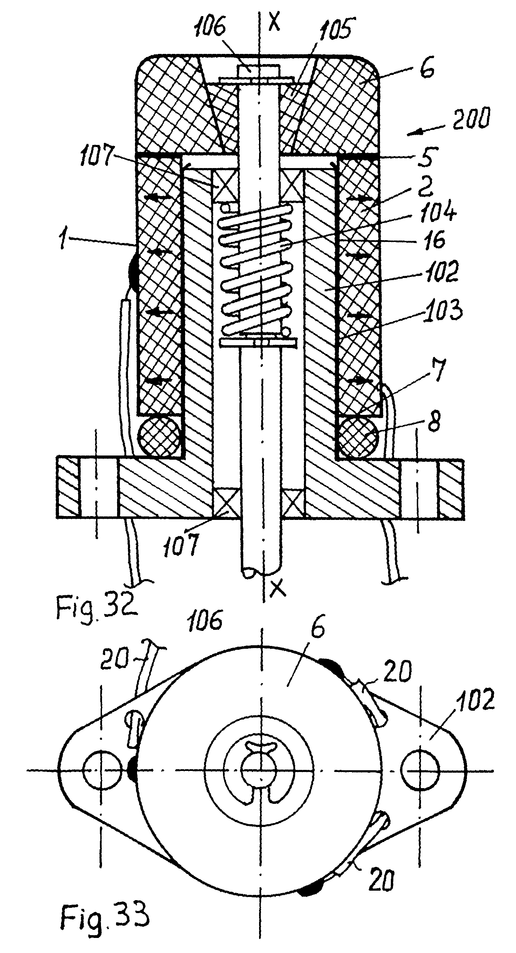

Die Figuren 32 und 33 zeigen eine Variante des erfindungsgemäßen piezoelektrischen Motors mit einem in seiner Längsachse X-X gestreckten Oszillator 2 und mit einem (oder zwei) Wanderwellengenerator(en). Ein piezoelektrischer Motor 200 besteht aus dem Stator 11 mit dem Oszillator 2, der gleichzeitig den Wellenleiter 3 für die Longitudinalwanderwelle bildet. Der Oszillator 2 ist auf einem Grundkörper 102 frei beweglich angeordnet. Wenn der Grundkörper 102 aus Metall gefertigt ist, muß zwischen diesem und dem Oszillator 2 eine Isolierunterlage 103 vorhanden sein, die einen Kurzschluß der Elektrode 16 (77) mit dem Stator 11 des Motors verhindert. Mit seiner funktionsfreien Stirnfläche 7 stützt sich der Oszillator 2 auf der schallisolierenden Unterlage 8 ab. An die Funktionsfläche 5 des Oszillators 2 wird der Rotor 6, der über eine elastische Buchse 105 mit einer Motorachse 106 verbunden ist, mit Hilfe einer Feder 104 angepreßt. Die Achse 106 ist durch Kugellager 107 so gelagert, daß sie sich in ihrer Längsrichtung frei bewegen und damit den Anpreßdruck der Feder 104 auf den Rotor 6 übertragen kann.

Bei Erzeugung einer Wanderwelle im Oszillator 2 überträgt die Funktionsfläche 5 des Oszillators 2 auf den Rotor 6 ein Drehmoment und veranlaßt ihn dadurch, sich zu drehen. Diese Drehung wird über die elastische Buchse 105 auf die Motorachse 106 übertragen. Beim Anlegen einer mechanischen Last auf die Achse 106, erzeugt der Oszillator 2 ein Drehmoment entgegengesetzt zum dem auf die Achse 106 und den Rotor 6 wirkenden Drehmoment. Da sich der Oszillator 2 mit seiner Stirnfläche 7 auf die schallisolierende Unterlage 8 abstützt, wird die Drehung des Oszillators 2 durch das Reibmoment zwischen Unterlage 8 und der Stirnfläche 7 verhindert. Dieses Reibmoment ist immer größer als das Drehmoment im Friktionskontakt des Motor, deshalb verharrt der Oszillator 2 in Ruhelage. Diese Motorvariante zeigt eine einfache Konstruktion, die eine schnelle Montage ermöglicht. Sie kann mit kleinen Abmessungen hergestellt werden. Da ihr Außendurchmesser nur 2-3 mm betragen kann, stellt sie eine ernste Konkurrenz zu herkömmlichen Elektromotoren dar.

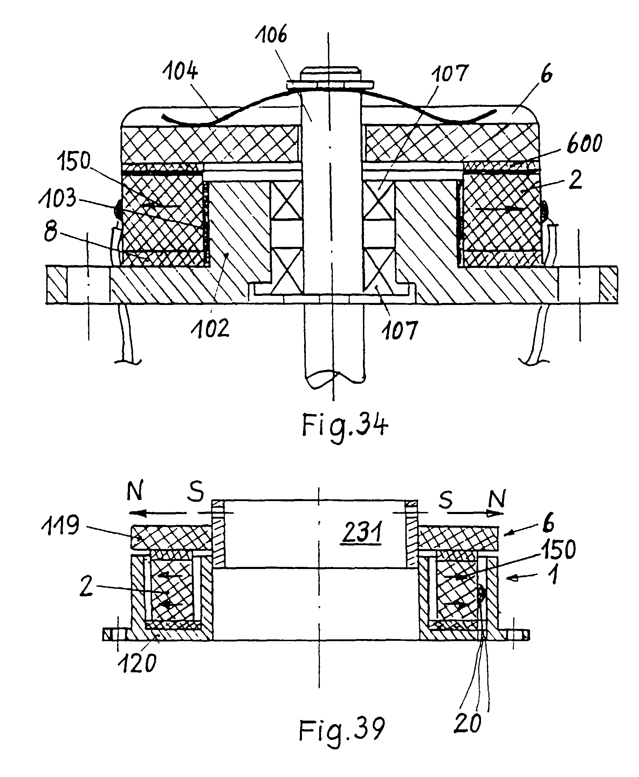

Figur 34 zeigt den erfindungsgemäßen Motor mit einem Ringoszillator 2, der einen ausreichend großen Durchmesser (größer 120 mm) und eine ausreichend große Funktionsfläche 5 (15-20 mm Ringbreite) besitzt. Im Oszillator 2 können mehr als zehn Wanderwellengeneratoren 4 untergebracht werden. Dadurch werden große Motorleistungen gewährleistet. Deshalb müssen bei dieser Ausführung der Grundkörper 102 und der Rotor 6 zur Ableitung der während des Motorbetriebs im Oszillator 2 entstehende Wärme über eine gute Wärmeleitfähigkeit verfügen. Für diese Zwecke ist Aluminium und seine Legierungen vorteilhaft einsetzbar. In dieser Variante ist der Rotor 6 des Motors mit einer dünnen, die Friktionseigenschaften des Rotors 6 bestimmenden Friktionsschicht 600 versehen.

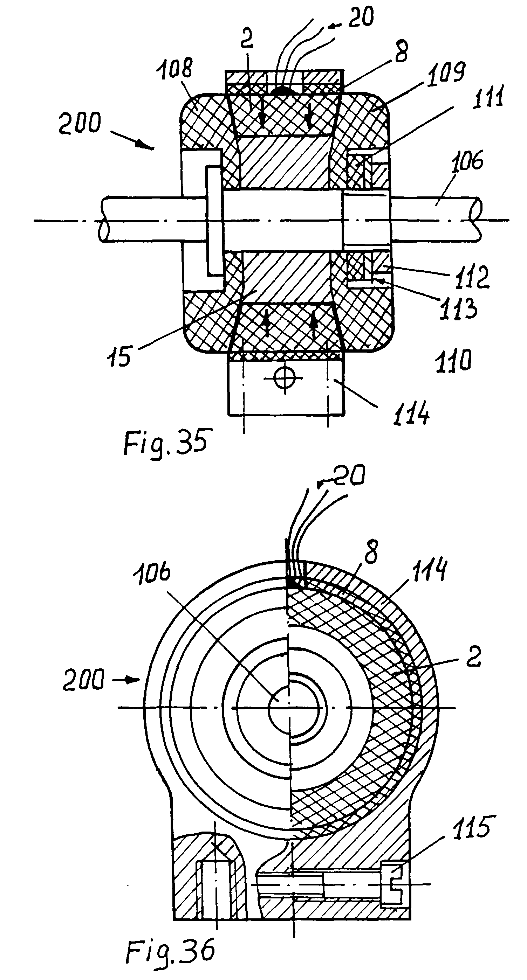

Die Figuren 35 und 36 zeigen einen piezoelektrischen Leistungsmotor 200. Dieser Motor hat einen aus den zwei Teilen 108 und 109 bestehenden Rotor. Das Teil 108 ist fest mit der Achse 106 verbunden. Das Teil 109 kann sich längs der Achse 106 bewegen. Beide Rotorteile werden an zwei konische Funktionsflächen 110 des zylindrischen Oszillators 2 mittels einer elastischen Unterlage 111 angepreßt, die wiederum durch eine Schraubenmutter 112 zwischen dem Teil 109 und einer Scheibe 113 gepreßt wird. Die elastische Unterlage 111 kann aus einem elastischen synthetischen Material wie z.B. Polyurithan gefertigt werden. Der Oszillator 2 dieses Motors ist in einem Gehäuse 114 untergebracht, das durch einen Bügel mit gestauchtem Bolzen dargestellt ist. Der Motor hat keine Lager. Sein Rotor 108, 109 wird durch die konischen Funktionsflächen 110 des Oszillators 2 zentriert. Diese Konstruktion ermöglicht eine maximale Leistung des piezoelektrischen Motors. Diese Leistung wird nur durch die dynamische Festigkeit des piezokeramischen Oszillators 2 begrenzt.

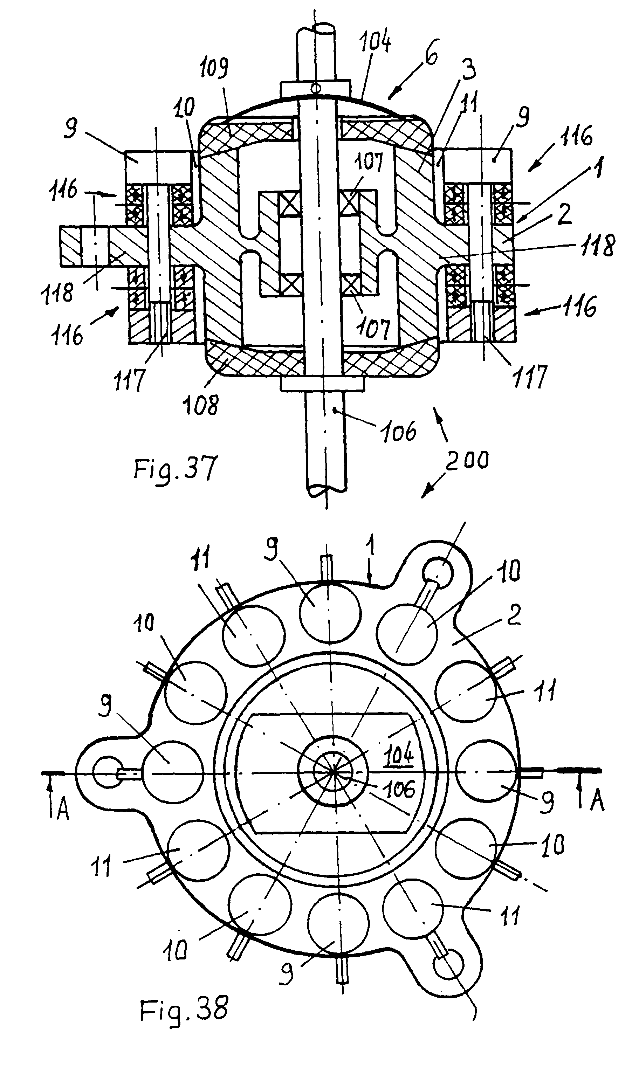

Eine mögliche Variante eines nicht-erfindungsgemäßen Motors 200 ist in den Figuren 37 und 38 dargestellt. Er besteht aus dem Stator 11 und dem Oszillator 2 mit dem metallischen Wellenleiter 3. Der Wellenleiter 3 wird aus einem stabilen, wärmebehandelten Stahl gefertigt, was maximale mechanische Spannungen in Wellenleiter zuläßt. Diese sind für Stahl bedeutend größer als für die piezoelektrische Keramik. Ein solcher Motor ermöglicht deshalb maximale Leistungen pro Volumeneinheit des Wellenleiters. Die Stehwellengeneratoren werden in der vorliegenden Konstruktion in Form eines Paketes von piezoelektrischen Wandlern 116 gefertigt, die durch Bolzen 117 zusammengepreßt werden. Sie werden koaxial zur Achse 106 und um den Wellenleiter 3 herum angeordnet und sind mit ihm mittels einer Lasche 118 verbunden.

Dieser Motor arbeitet folgendermaßen. Jede Paketgruppe von piezoelektrischen Wandlern 116, die einen Stehwellengenerator 9, 10, 11 bilden, erzeugt im Wellenleiter 3 seine Stehwelle 26, 27, 28 (Fig. 7). Die Überlagerung dieser Wellen ergibt die Wanderwelle 29, die den Rotor 6 dreht.

Diese Konstruktion des piezoelektrischen Motors mit piezoelektrischen Wandlerpaketen ermöglicht es, die mechanische Leistung des Motors durch Vergrößern der Paketzahl und entsprechend des Durchmessers des Wellenleiters unbegrenzt zu erhöhen. Jedes Paket mit einem Durchmesser von 30 mm hat eine Grenzwandlungsleistung von etwa 100 W. Bei dreißig Paketen auf dem Oszillator 2 und einem Wirkungsgrad des piezoelektrischen Motors von 30-40 %, kann eine mechanische Leistung von etwa 100 W auf der Motorachse 106 erreicht werden.

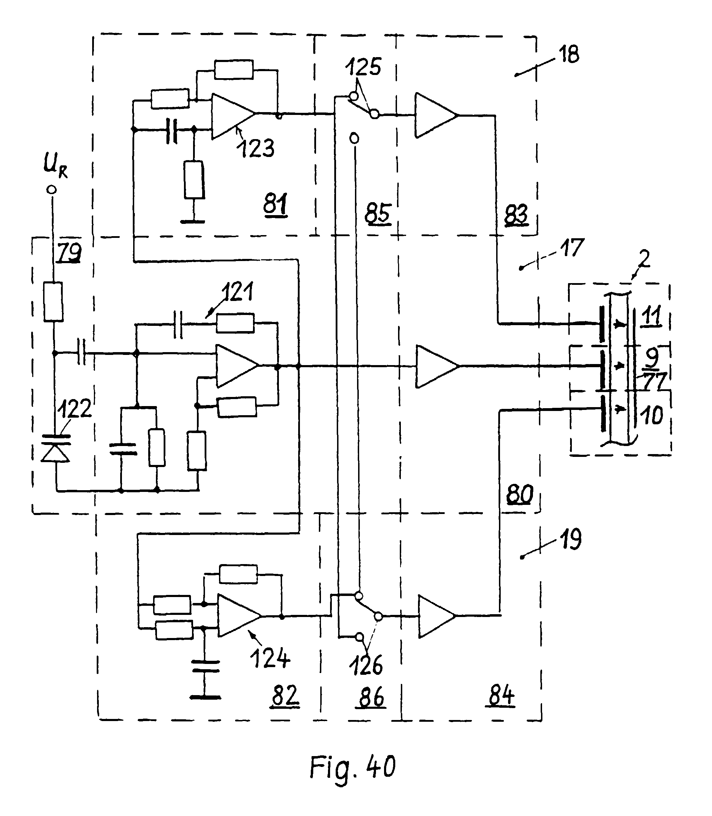

Entsprechend den Forderungen der konkreten Anwendung ermöglicht die Erfindung verschiedene Modifikationen für den piezoelektrischen Motor. Fig. 39 zeigt eine Variante eines für den Einsatz in speziellen optischen Systemen vorgesehen Motors. Der Motor hat eine große zentrale Öffnung 231. Der Rotor 6 wird mittels des Magnetrings 119, der wiederum vom magnetischen Gehäuse 120 angezogen wird, an den Oszillator 2 gepreßt.

Die Erfindung umfaßt unterschiedliche Ausführungsvarianten der Erregerquellen der Stehwellengeneratoren 9, 10, 11 des Oszillators 2, von denen nachfolgend vier Varianten mit den wichtigsten Konstruktionselementen beschrieben werden.

Figur 40 zeigt die elektrische Prinzipschaltung des erfindungsgemäßen Motors, der nach dem Prinzip der Frequenzsteuerung die Drehgeschwindigkeit des Rotors regelt. Diese Schaltung entspricht den Blockschaltbildern nach den Figuren 25 und 26. Die Schaltung besteht aus der Quelle 17 des Grundgenerators 9, der den Steuergenerator 79 und den Leistungsverstärker 80 einschließt.

Der Steuergenerator 79 ist nach dem Prinzip des Autogenerators mit Wien-Brücke aufgebaut. Die Frequenz des Steuergenerators 79 kann mittels der Steuerspannung $U_R$ variiert werden, die auf einen Kondensator 122 wirkt und dessen elektrische Kapazität ändert. Die Kapazität des Kondensators 122 ist so gewählt, daß ihre Änderung die Frequenz des Steuergenerators 79 in dem in Fig. 16, Position 41 dargestellten Bereich der Frequenzcharakteristik ändert. In dieser Variante enthalten die Quellen 18, 19 der Zusatzgeneratoren 10, 11 die Phasendrehglieder 81, 82, die Vorrichtungen zur Umpolung des Phasenwinkels 85, 86 und die Leistungsverstärker 83, 84. Die Phasendrehglieder 81, 82 sind aktive Phasenschieberzweige 123, 124 mit Operationsverstärkern, die die Phasen der Signale entsprechend um $+ 2\pi/3$ (+120°) und $- 2\pi/3$ (-120°) drehen. Die Vorrichtungen 85, 86 erden Umschalter 125, 126, die den funktionellen Tausch der Phasendrehglieder 81, 82 durchführen, d.h. das Vorzeichen der Phasenverschiebung ändern. Eine solche Umschaltung ermöglicht die Drehrichtung des Rotors 6 umzukehren. Die Verstärker 80, 83, 84 sind identisch und stellen Pufferverstärker (Leistungsverstärker) dar, die einen großen Durchlaßbereich aufweisen und fast im Schaltbetrieb arbeiten. Die betrachtete Vorrichtung arbeitet sowohl links als auch rechts der mechanischen Resonanzfrequenz $f_0$ des Oszillators 2 sicher.

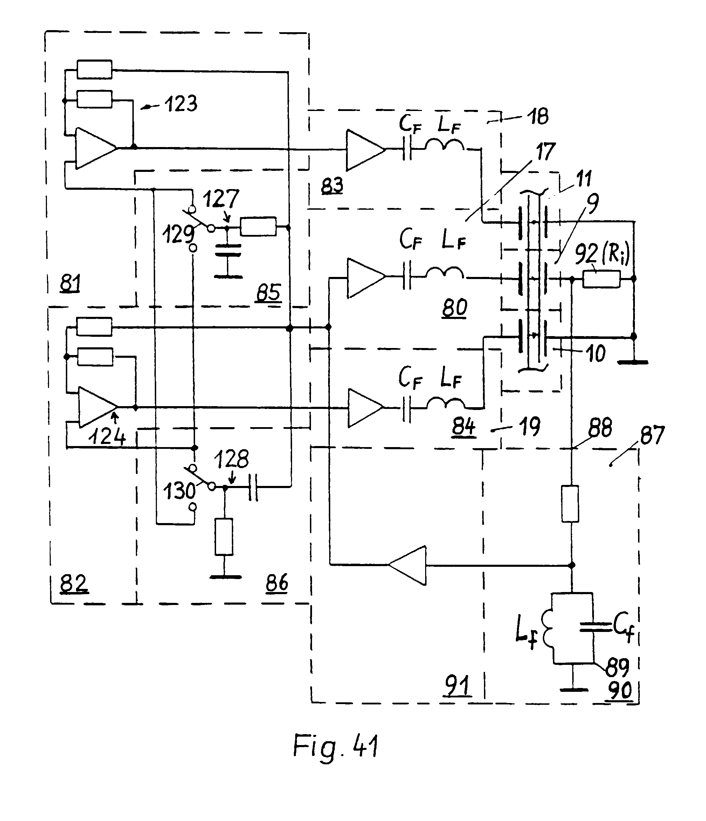

In Fig. 41 ist eine prinzipielle Schaltung entsprechend dem Blockschaltbild Fig. 27 (Autogenerator) dargestellt. In der Schaltung ist der Eingang des Rückkopplungszweiges 87 mit dem als Stromwiderstand $R_i$ ausgeführten Impedanzelement 92. Die an diesem Widerstand $R_i$ anliegende Spannung ist proportional dem durch den Grundgenerator 9 fließenden Strom. Die Phasenverschiebung dieser Spannung bei der Frequenz $f_0$ ist im Verhältnis zur Spannung am Generator 9 praktisch gleich Null. Vom Widerstand $R_i$ gelangt die dem Strom proportionale Spannung auf das Bandfilter 89 ($L_f$, $C_f$) und danach auf den Verstärker 91. Das auf die Frequenz $f_0$ abgestimmte Bandfilter 89 begrenzt den Durchlaßbereich des Rückkopplungszweiges 86 und verhindert damit eine Selbsterregung des Schaltung im Bereich der Parasitärfrequenzen des Oszillators 2. Die vom Verstärker 91 verstärkte Spannung gelangt auf den Ausgang des Rückkopplungszweiges 87 und von da auf den Leistungsverstärker 80 der Quelle 17 des Grundgenerators 9. Da die Gesamtphasenverschiebung im geschlossenen Kreis bei der Frequenz $f_0$ gleich Null ist, ist der Verstärkungsfaktor bei dieser Frequenz größer als Eins, und die Quelle 17 mit dem Rückkopplungszweig 87 fängt bei der Frequenz $f_0$ an zu schwingen und wirkt demzufolge als Autogenerator, der diese Frequenz trotz Einwirkung destabilisierender Einflüsse beibehält. Die Phasendrehglieder 81, 82 enthalten die Phasenschieberzweige 123, 124, die wiederum zwei untereinander umschaltende Phasenketten 127, 128 enthalten. Die Umschaltung erfolgt mit Umschaltern 129, 130, die faktisch eine Umkehrung der Vorzeichen der Phasenverschiebung erzeugen. Eine solche Umschaltung ermöglicht die Drehrichtung des Rotors 6 umzukehren. Die Leistungsverstärker 80, 83, 84 sind über die Trennfilter $L_f C_f$ mit den Generatoren 9, 10, 11 verbunden. Dies ermöglicht die Verstärker im Schaltbetrieb zu betreiben, in dem die Ausgangsspannung steilen Fronten haben.

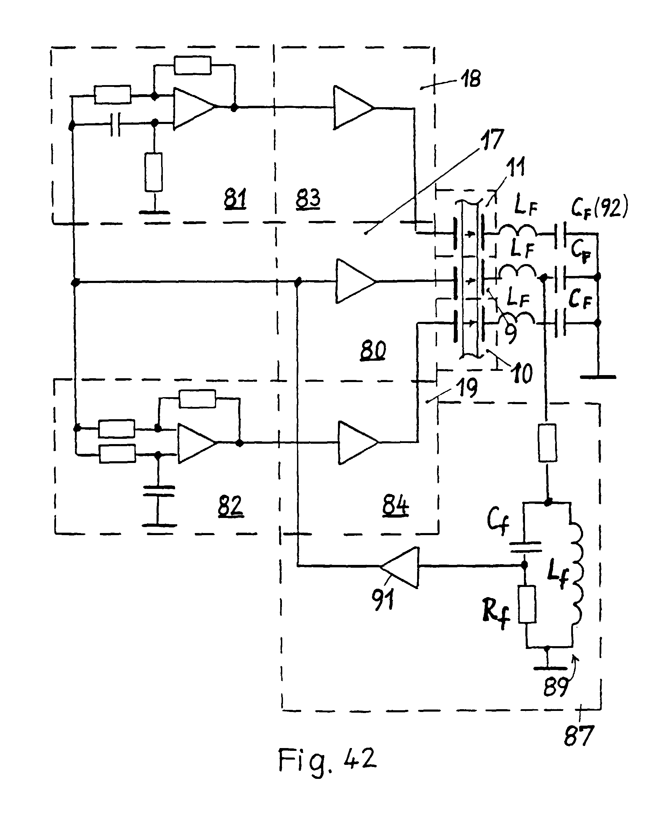

Figur 42 zeigt eine Ausführungsvariante, in der der Kondensator $C_F$ des Trennfilters $L_F C_F$ als Impedanzelement 92 verwendet wird. Die Spannungsamplitude auf diesem Kondensator ist proportional zum Strom durch den Generator 9. Die Phase ist jedoch bezüglich des Generatorstrom um -90° gedreht. Eine solche Phasenverschiebung erfordert eine nochmalige Drehung um -90°. Diese Drehung erfolgt im Kondensatorkreis $C_f$ des Bandfilters 89, wo die Spannung am Widerstand $R_f$ im Verhältnis zum Kondensatorstrom $C_f$ um -90° gedreht ist. Dabei beträgt die Gesamtphasenverschiebung -180°. Nochmals um -180° dreht der Verstärker 91 die Phase, so das die Gesamtphasenverschiebung gleich Null wird. Da in dieser Variante die Drehrichtung des Rotors 6 nicht umkehrbar ist, enthält er keine Vorrichtungen 85 und 86.

In allen betrachteten Varianten der in den Figuren 40, 41, 42 dargestellten Funktionsteile eines erfindungsgemäßen Motors 200 werden als Pufferverstärker 80, 83, 84 Halb-Brückenschaltungen mit bipolaren oder Feldeffekttransistoren (nicht dargestellt) verwendet, die als Spannungsschalter betrieben werden. Solche Schaltungen ermöglichen elektrische Spannungsamplituden an den Generatoren 9, 10, 11, die gleich der halben Versorgungsspannung sind. Falls höhere Spannungen gefordert werden, können Schaltungen mit Stromumschaltern verwendet werden. Diese Schaltungen ermöglichen eine Spannung an den Generatoren 9, 10, 11, die um das 2-3 fache höher ist als die Versorgungsspannung der Leistungsverstärker.

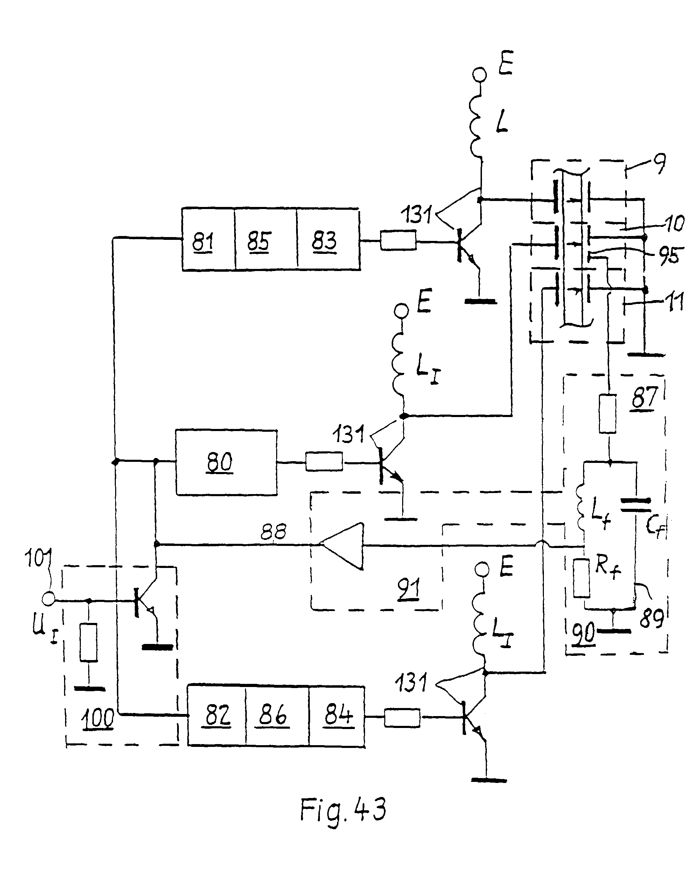

Figur 43 zeigt eine Variante des erfindungsgemäßen Motors mit Stromschaltern. Diese Variante enthält drei Stromumschalter 131, die von der Spannung E gespeist und als bipolare Transistoren mit einer Stromquelle in Form einer im Kollektorkreis enthaltenen Induktivität $L_l$ ausgeführt sind. Die Spannungsamplitude an den Generatoren 9, 10, 11 beträgt etwa (2-3)·E. In dieser Variante ist der Rückkopplungszweig 87 mit der Rückkopplungselektrode 95 verbunden, die bei der Frequenz $f_0$ eine Phasenverschiebung von +90° zwischen der Spannung am Generator 9 und der Spannung an dieser Elektrode 95 erzeugt (Fig. 29, Position 97). Die Phasenschieberkette 90 des Bandfilters 89 dreht die Phase nochmals um +90°, so das die Gesamtphasenverschiebung +180° beträgt. Die Drehung der Phase in Gegenrichtung um -180° erfolgt durch den Verstärker 91. Diese Ausführungsvariante stellt einen entsprechend Blockschaltbild Fig. 31 aufgebauten piezoelektrischen Motor im Schrittbetrieb mit kleiner Start-Stopp-Zeit dar. Für den Schrittbetrieb enthält die Schaltung einen Transistorschalter 100, der durch die Impulsspannung am Eingang 101 gesteuert wird. Beim Schließen des Schalters 100 wird die Rückkopplung aufgetrennt, was einen forcierten Abbruch der Schwingungen des elektromechanischen Generators zur Folge hat. Beim Öffnen des Schalters 100 wird der Autogenerator forciert gestartet.

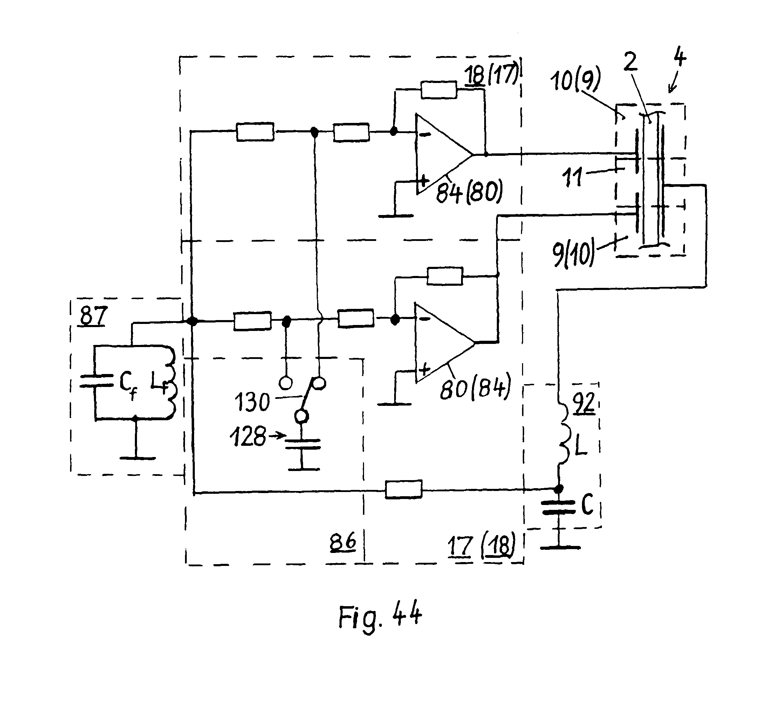

Fig. 44 zeigt die elektrische Schaltung des erfindungsgemäßen piezoelektrischen Motors, bei der Teile der Spannungen $U_1$ und $U_2$ summiert werden, die die Generatoren 9 und 10 erregen. Die Schaltung ist so aufgebaut, daß beim Betätigen eines Umschalters 130 die Erregerquellen 17 und 18 und die Generatoren 9 und 10 funktionell vertauscht werden. Dies ermöglicht auf einfache Weise eine Umkehr der Drehrichtung des Motors. Im übrigen gelten die bisher verwendeten Bezugszeichen.

In allen möglichen Varianten des erfindungsgemäßen piezoelektrischen Motors füllt die piezoelektrische Keramik das maximal mögliche Volumen des Oszillators aus. Deshalb zeichnen sich solche Motoren durch einen hocheffektiven Oszillator mit einem maximalen elektromechanischen Koeffizienten aus. Sie benötigen nur geringe Erregerspannungen und sind hoch belastbar, d.h. sie arbeiten auch bei hoher mechanischer Belastung des Oszillators. Der monolithische Oszillator solcher Motoren weist eine hohe Festigkeit auf, was maximale mechanische Spannungen und damit maximale Schwingungsgeschwindigkeiten zuläßt, und deshalb maximale mechanische Leistungen an der Motorachse ermöglicht.

So entwickelt der Motor bei einer spezifischen Tangentiallast auf der Funktionsfläche des Oszillators von 10 N/cm$^2$ und einer Schwingungsgeschwindigkeit der Funktionsfläche von 1 m/s z.B. eine spezifische mechanische Leistung von 10 W/cm$^2$ Funktionsfläche. Das heißt bei einem Oszillatordurchmesser von 100 mm und einer 15 mm breiten Funktionsfläche beträgt die maximal mögliche mechanische Leistung des Motors 450 W.

Die hohe mechanische Festigkeit des Oszillators bestimmt die hohe Funktionssicherheit und Standzeit des Motors, die sich an die Ausfallsicherheit von massiven Bauelementen annähert. Die einfache Konstruktion senkt den Selbstkostenpreis, was die Konkurrenzfähigkeit des Motors mit herkömmlichen Elektromotoren ermöglicht.

**Patentansprüche**

1. Piezoelektrischer Motor (200) mit einem Stator (1), der einen Oszillator (2) in Form eines geschlossenen, im wesentlichen hohlzylindrischen Wellenleiters (3) mit über Elektroden (15, 16) an elektrische Erregerquellen (17, 18, 19) angeschlossenen Generatoren (9, 10, 11) für gleiche, gegeneinander verschobene Stehwellen aufweist, die sich zu einer elastischen Wanderwelle überlagern, und mit einem Rotor (6), der sich in Friktionskontakt mit einer die Wellenbewegung vollführenden Funktionsfläche (5) des Oszillators (2) befindet, wobei die Elektroden (15, 16) zu beiden Seiten des Wellenleiters (3) angeordnet sind und die Länge des Wellenleiters (3) gleich der Wellenlänge der Stehwelle oder einem ganzzahligen Vielfachen dieser Wellenlänge ist, **dadurch gekennzeichnet**, daß der Oszillator (2) vollständig aus piezoelektrischem Material besteht, die Elektroden (15, 16) rechtwinklig zur einheitlichen Polarisationsrichtung (150) angeordnet sind, daß die Generatoren (9, 10, 11) einen Grundgenerator (9) und zwei Zusatzgeneratoren (10, 11) umfassen, die Generatoren (9, 10, 11) drei Longitudinalstehwellen erzeugen, die Zusatzgeneratoren (10, 11) im Abstand von ± 1/3 der Wellenlänge der Longitudinalstehwellen und so angeordnet sind, daß die von ihnen erzeugten Longitudinalstehwellen zu der vom Grundgenerator (9) erzeugten Longitudinalstehwelle im wesentlichen um ± 2π/3 phasenverschoben sind, wobei die Generatoren (9, 10, 11) einen Longitudinalwanderwellengenerator bilden, derart, daß die von den drei Generatoren (9, 10, 11) erzeugten Longitudinalstehwellen durch Überlagerung eine Longitudinalwanderwelle bilden.

2. Piezoelektrischer Motor nach Anspruch 1, **dadurch gekennzeichnet**, daß am hohlzylindrischen Wellenleiter (3) mindestens zwei solche Wanderwellengeneratoren (4) zur Erzeugung einer solchen elastischen Wanderwelle um die Zylinderlängsachse (X-X) regelmäßig verteilt angeordnet sind.

3. Piezoelektrischer Motor nach Anspruch 2, **dadurch gekennzeichnet**, daß die Länge jedes Wanderwellengenerators (4) gleich der Wellenlänge oder einem ganzzahligen Vielfachen der Wellenlänge der Wanderwelle ist.

4. Piezoelektrischer Motor nach Anspruch 3, **dadurch gekennzeichnet**, daß bei jedem Wanderwellengenerator (4) ein Zusatzgenerator (11) durch den anderen Zusatzgenerator (10) und den Grundgenerator (9) derart determiniert ist, daß er mit dem anderen Zusatzgenerator (10) und dem Grundgenerator (9) als Teiler für die von deren Erregerquellen (18, 19) gelieferten Spannungen und als Summenbildner für die so erhaltenen Teilpannungen wirkt.

5. Piezoelektrischer Motor nach Anspruch 11 oder 4, **dadurch gekennzeichnet**, daß der geschlossene Wellenleiter (3) aus piezoelektrischer Keramik besteht.

6. Piezoelektrischer Motor nach mindestens einem der Ansprüch 11 bis 5, **dadurch gekennzeichnet**, daß die Funktionsfläche (5) des Oszillators (3) mit einer dünnen verschleißfesten Friktionsschicht (60) versehen ist, die in Kontakt mit dem Rotor (6) steht.

7. Piezoelektrischer Motor nach Anspruch 6, **dadurch gekennzeichnet**, daß die Friktionsschicht (60) vollständig aus einem Material besteht, das eine chemische Verbindung mit dem Material des geschlossenen Wellenleiters (3) bildet.

8. Piezoelektrischer Motor nach Anspruch 6, **dadurch gekennzeichnet**, daß die Friktionsschicht (60) aus einer Grund- und einer Zwischenschicht besteht, wobei die Grundschicht (63) die Friktionseigenschaften bestimmt und die Zwischenschicht (64) eine chemische Verbindung mit den Materialien des geschlossenen Wellenleiters (3) und der Grundschicht (63) bildet.

9. Piezoelektrischer Motor nach Anspruch 6, **dadurch gekennzeichnet**, daß die Friktionsschicht (60) aus einem zusammengesetzten Material besteht, dessen Grundlage ein Material bildet, das eine chemische Verbindung mit dem Material des geschlossenen Wellenleiters (3) eingeht, dem ein Füllstoff beigemengt ist, der den Reibungskoeffizienten der Friktionsschicht (60) erhöht.

10. Piezoelektrischer Motor nach Anspruch 6, **dadurch gekennzeichnet**, daß die Friktionsschicht (60) aus einem porösen Material mit hohem Reibungskoeffizienten besteht, wobei die Poren dieses Materials mit einem anderen Material angefüllt sind, das eine chemische Verbindung mit dem geschlossenen Wellenleiter (3) eingeht.

11. Piezoelektrischer Motor nach einem der Ansprüche 1 bis 5, **dadurch gekennzeichnet**, daß Leistungsverstärker (83, 84) die Erregerquellen der zwei Zusatzgeneratoren (10, 11) darstellen und über Phasendrehglieder (81, 82) mit der Erregerquelle (17) des Grundgenerators (9) verbunden sind.

12. Piezoelektrischer Motor nach Anspruch 11, **dadurch gekennzeichnet**, daß die Erregerquellen (18, 19) der Zusatzgeneratoren (10, 11) mit Vorrichtungen zur Umpolung des Phasenwinkels (125, 126) ausgerüstet sind.

13. Piezoelektrischer Motor nach Anspruch 11, **dadurch gekennzeichnet**, daß ein frequenzgesteuerter Spannungsgenerator die Erregerquelle des Grundgenerators (9) darstellt.

14. Piezoelektrischer Motor nach Anspruch 1, **dadurch gekennzeichnet**, daß der Grundgenerator (9) und seine Erregerquelle (17) einen positiven Rückkopplungszweig (87) haben und zusammen einen elektromechanischen Autogenerator bilden.

**15.** Piezoelektrischer Motor nach Anspruch 14, **dadurch gekennzeichnet**, daß der positive Rückkopplungszweig (87) mit einem Impedanzelement (92) verbunden ist, welches in Reihe mit dem Grundgenerator (9) geschaltet ist.

**16.** Piezoelektrischer Motor nach Anspruch 14, **dadurch gekennzeichnet**, daß der positive Rückkopplungszweig (87) an einen Stromwandler (131) angeschlossen ist, der in Reihe mit dem Grundgenerator (9) geschaltet ist.

**17.** Piezoelektrischer Motor nach Anspruch 14, **dadurch gekennzeichnet**, daß der positive Rückkopplungszweig (87) mit einer Rückkopplungselektrode (95) verbunden ist.

**18.** Piezoelektrischer Motor nach Anspruch 14, **dadurch gekennzeichnet**, daß er mit einen elektronischen Schalter (100) mit Steuereingang ausgerüstet ist, der den positiven Rückkopplungszweig (87) unterbricht.


**Claims**

**1.** A piezoelectric motor (200) comprising a stator (1) being provided with an oscillator (2) in the form of a closed substantially hollow cylindrical waveguide (3) with generators (9, 10, 11) connected via electrodes (15, 16) to electric excitation sources (17, 18, 19) adapted to generate equal and mutually displaced standing waves which superimpose to an elastic traveling wave, and with a rotor (6) in friction contact with an operational face (5) of said oscillator (2) performing the wave movement, with the electrodes (15, 16) being arranged on both sides of the waveguide (3) and the length of the waveguide (3) is equal to or a multiple integer of the wavelength of the standing wave, characterized in that said oscillator (2) entirely consists of piezoelectric material, and in that said electrodes (15, 16) are arranged at right angles to the uniform polarization direction (150) and in that said generators (9, 10, 11) comprise a basic generator (9) and two boosters (10, 11), the generators (9, 10, 11) being adapted to generate three longitudinal standing waves, said boosters (10, 11) arranged at a distance of $\pm 1/3$ of the wavelength of the longitudinal standing wave and in such a manner that the longitudinal standing waves generated by the former are phase-shifted substantially by $\pm 2\pi/3$ relative to longitudinal standing wave generated by the basic generator (9), wherein the generators (9, 10, 11) form a longitudinal wandering wave generator in such a manner that the longitudinal standing waves generated by said generators (9, 10, 11) form a longitudinal wandering wave by superimposition.

**2.** A piezoelectric motor as claimed in claim 1, characterized in that at least two such wandering wave generators (4) for generating such elastic wandering waves are arranged uniformly distributed about the cylinder longitudinal axis (X-X) at the hollow cylindrical waveguide (3).

**3.** A piezoelectric motor as claimed in claim 2, characterized in that the length of each wandering wave generator (4) is equal to or a multiple integer of the wavelength of the wandering wave.

**4.** A piezoelectric motor as claimed in claim 3, characterized in that in each wandering wave generator (4) one booster (11) is determined by the other booster (10) and the basic generator (9) in such a manner that the former, in combination with the other booster (10) and the basic generator (9), operates as a voltage divider with respect to voltages delivered by their excitation sources (18, 19), and as a summator with respect to the partial voltages obtained in this manner.

**5.** A piezoelectric motor as claimed in claim 11 or 4, characterized in that the closed waveguide (3) is made of piezoelectric ceramics.

**6.** A piezoelectric motor as claimed in at least one of the claims 1 to 5, characterized in that said operational face (5) of the oscillator (3) is provided with a thin wear resistant friction layer (60) contacting said rotor (6).

**7.** A piezoelectric motor as claimed in claim 6, characterized in that said friction layer (60) entirely consists of a material forming a chemical compound with the material of the closed waveguide (3).

**8.** A piezoelectric motor as claimed in claim 6, characterized in that said friction layer (60) consists of a basic layer and an intermediate layer, said basic layer (63) determining the friction properties and the intermediate layer (64) forming a chemical compound with the materials of the closed waveguide (3) and of the basic layer (63).

**9.** A piezoelectric motor as claimed in claim 6, characterized in that said friction layer (60) consists of a composite material, the base of said material forming a chemical compound with the material of said closed waveguide (3) to which a filler material is added which increases the friction coefficient of the friction layer (60).

**10.** A piezoelectric motor as claimed in claim 6, characterized in that said friction layer (60) consists of a porous material of high friction coefficient, the pores of said material being filled with a different material forming a chemical compound with said closed waveguide (3).

**11.** A piezoelectric motor as claimed in one of the preceding claims 1 to 5, characterized in that the excitation sources of the two boosters (10, 11) are power amplifiers (83, 84) being connected to the excitation source (17) of the basic generator (9) via phase shift members (81, 82).

**12.** A piezoelectric motor as claimed in claim 11, characterized in that the excitation sources (18, 19) of the boosters (10, 11) are provided with means for pole reversal of the phase angles (125, 126).

**13.** A piezoelectric motor as claimed in claim 11, characterized in that the excitation source of the basic generator (9) is a frequency-controlled voltage generator.

**14.** A piezoelectric motor as claimed in claim 1, characterized in that the basic generator (9) and its excitation source (17) are provided with a positive feedback branch (87) and, together, constitute an electromechanic autogenerator.

**15.** A piezoelectric motor as claimed in claim 14, characterized in that the positive feedback branch (87) is connected to an impedance (92) being series-connected to the basic generator (9).

**16.** A piezoelectric motor as claimed in claim 14, characterized in that the positive feedback branch (87) is connected to a current reversal circuit (131) being series-connected to the basic generator (9).

**17.** A piezoelectric motor as claimed in claim 14, characterized in that the positive feedback branch (87) is connected to a feedback electrode (95).

**18.** A piezoelectric motor as claimed in claim 14, characterized in that said motor is provided with an electronic switch (100) including a control input for breaking said positive feedback branch (87).

**Revendications**

**1.** Un moteur piézoélectrique (200) constitué d'un stator (1) doté d'un oscillateur (2) en forme d'un guide d'onde (3) fermé, dans l'essentiel cylindrique et creux, comprenant des générateurs (9, 10, 11) connectés à des sources d'excitation électriques (17, 18, 19) à l'aide d'électrodes (15, 16), conçues pour ondes stationnaires qui sont déphasées les unes par rapport aux autres et qui se superposent formant ainsi une onde élastique progressive, d'un rotor (6) en contact par friction avec une face fonctionnelle (5) en ondulation de l'oscillateur (2) , les électrodes (15, 16) étant disposées sur les deux côtés du guide d'ondes (3) dont la longueur est égale à la longueur d'onde de l'onde stationnaire ou à un multiple entier de cette longueur d'onde, **est caractérisé en ce que** l'oscillateur (2) est entièrement fabriqué en matériaux piézoélectriques, que les électrodes (15, 16) sont disposées de manière perpendiculaire par rapport au sens unique de polarisation (150), que les générateurs comprennent un générateur principal (9) et deux générateurs auxiliaires (10, 11), que les générateurs (9, 10, 11) génèrent trois ondes stationnaires longitudinales, qui sont disposés à une distance égale à $\pm$ 1/3 de la longueur d'onde des ondes stationnaires longitudinales de manière à ce que les ondes stationnaires longitudinales qu'ils génèrent, sont déphasées de $\pm 2\pi/3$ par rapport à l'onde stationnaire longitudinale générée par le générateur principal, les générateurs (9, 10, 11) formant ainsi un générateur d'ondes longitudinales progressives de manière que les ondes longitudinales stationnaires générées par les trois générateurs (9, 10, 11) forment en raison de la superposition des ondes générées, une onde longitudinale progressive.

**2.** Le moteur piézoélectrique selon la revendication 1 **est caractérisé en ce que** sur le guide d'onde cylindrique creux (3) au moins deux générateurs d'ondes progressives de ce genre (4) sont disposés régulièrement autour de l'axe longitudinal du cylindre (X-X) pour générer une telle onde progressive élastique.

**3.** Le moteur piézoélectrique selon la revendication 2 **est caractérisé en ce que** la longueur de chacun des générateurs d'ondes progressives (4) est égale à la longueur d'onde ou à un multiple entier de la longueur d'onde de l'onde progressive.

4. Le moteur piézoélectrique selon la revendication 3 **est caractérisé en ce que** sur chaque générateur d'ondes progressives (4) l'un des générateurs auxiliaires (11) est déterminé par l'autre générateur auxiliaire (10) et le générateur principal (9) de sorte qu'il fonctionne, en commun avec l'autre générateur auxiliaire (10) et le générateur principal (9), comme diviseur de tension pour les autres tensions fournies par leurs sources d'excitation (18, 19) et comme totalisateur des tensions partielles ainsi obtenues.

5. Le moteur piézoélectrique selon la revendication 1 ou 4 **est caractérisé en ce que** le guide d'onde fermé (3) est fabriqué en céramique piézoélectrique.

6. Le moteur piézoélectrique selon au moins une des revendications 1 à 5 **est caractérisé en ce que** la face fonctionnelle (5) de l'oscillateur (3) est pourvue d'une mince couche de friction résistant à l'usure (60) qui est en contact avec le rotor (6).

7. Le moteur piézoélectrique selon la revendication 6 **est caractérisé en ce que** la couche de friction (60) est fabriquée entièrement dans un seul matériau qui forme une liaison chimique avec le matériau dans lequel le guide d'ondes fermé (3) est fabriqué.

8. Le moteur piézoélectrique selon la revendication 6 **est caractérisé en ce que** la couche de friction (60) est composée d'une couche principale et d'une couche intermédiaire, la couche principale (63) étant décisive pour lés qualités de friction et la couche intermédiaire (64) étant chimiquement liée aux matériaux du guide d'ondes fermé (3) et de la couche principale (63).

9. Le moteur piézoélectrique selon la revendication 6 **est caractérisé en ce que** la couche de friction (60) se compose d'un matériau composite basé sur un matériau qui forme une liaison avec le matériau du guide d'ondes fermé (3), auquel est additionné une matière de charge destinée à augmenter la coefficient de friction de la couche de friction (60).

10. Le moteur piézoélectrique selon la revendication 6 **est caractérisé en ce que** la couche de friction (60) est fabriquée dans un matériau poreux caractérisé par un coefficient de friction élevé, les alvéoles de ce matériau étant rempli d'un autre matériau faisant fonction de charge et servant à établir une combinaison chimique avec le guide d'ondes fermé (3).

11. Le moteur piézoélectrique selon les revendications 1 à 5, **est caractérisé en ce que** les amplificateurs de puissance (83, 84) font fonction de sources d'excitation pour les deux générateurs auxiliaires, (10, 11) et qu'ils sont liés à la source d'excitation (17) du générateur principal (9) par l'intermédiaire d'éléments de rotation de phases (81, 82).

12. Le moteur piézoélectrique selon la revendication 11 **est caractérisé en ce que** les sources d'excitation (18, 19) des générateurs auxiliaires (10, 11) sont équipés de dispositifs permettant l'inversion de l'angle de phases (125, 126).

13. Le moteur piézoélectrique selon la revendication 11 **est caractérisé en ce qu'**un générateur de tension commandé par fréquences fait fonction de source d'excitation pour le générateur principal (9).

14. Le moteur piézoélectrique selon la revendication 1 **est caractérisé en ce que** le générateur principal (9) et sa source d'excitation (17) ont un circuit de rétroaction positive (87) et forment ensemble un autogénérateur électromécanique.

15. Le moteur piézoélectrique selon la revendication 14 **est caractérisé en ce que** le circuit de rétroaction positive (87) est relié à une impédance (92) montée en série avec le générateur principal (9).

16. Le moteur piézoélectrique selon la revendication 14 **est caractérisé en ce que** le circuit de rétroaction positive (87) est connecté à un transformateur d'intensité (131), monté en série avec le générateur principal (9).

17. Le moteur piézoélectrique selon la revendication 14 **est caractérisé en ce que** le circuit de rétroaction positive (87) est relié à une électrode de rétroaction (95).

**18.** Le moteur piézoélectrique selon la revendication 14 **est caractérisé en ce qu'**il est équipé d'un actionneur électronique (100) doté d'une entrée de contrôle permettant ainsi l'interruption du circuit de rétroaction positive (87).

Fig. 1

Fig. 2

Fig. 3

Fig.4

Fig.5

Fig.6

Fig. 7

EP 0 789 937 B1

Fig. 8

26

Fig.9

Fig.10

Fig. 11

Fig. 12

$U_1(U_2, U_3)$  34

35

36

Fig. 13

Fig. 14

Fig. 15

EP 0 789 937 B1

Fig. 16

Fig. 17

Fig. 18

EP 0 789 937 B1

Fig. 19

36

Fig. 20

Fig. 21

Fig. 22

Fig. 23

Fig. 24

Fig. 25

Fig. 26

EP 0 789 937 B1

Fig. 27

42

Fig.28

Fig. 29

Fig. 30

Fig. 31

Fig. 32

Fig. 33

Fig.34

Fig.39

Fig. 35

Fig. 36

Fig.37

Fig.38

Fig. 40

Fig. 41

Fig. 42

Fig.43

Fig. 44